# EUROPEAN PATENT APPLICATION

(11) **EP 4 503 890 A1**
(43) Date of publication of application: **05.02.2025**
(21) Application number: 24191790.5
(22) Date of filing: 30.07.2024
(51) Int. Cl.: H10K 50/11, H10K 59/124, H10K 59/131, H10K 59/80, H10K 59/88

(54) **DISPLAY DEVICE AND METHOD FOR FABRICATING THE SAME**

(30) Priority: 04.08.2023 KR 20230102176
(71) Applicant: Samsung Display Co., Ltd., Gyeonggi-do 17113 (KR)
(72) Inventor: BOK, Seung Lyong, Yongin-si (KR)
(74) Representative: Marks & Clerk LLP

(57) **Abstract**

According to an embodiment, a display device may include a substrate, a driver element layer disposed on the substrate, a line layer disposed on the driver element layer and including a first inorganic layer and a second inorganic layer disposed on the first inorganic layer, and a light-emitting element layer disposed on the line layer and including a plurality of first electrodes, an intermediate layer, and a second electrode sequentially stacked. The line layer may include a trench between the first electrodes, there being no first inorganic layer or the second inorganic layer in the trench. The first inorganic layer may include an undercut area in the trench under the second inorganic layer.

## Description

### BACKGROUND

### 1. Field of the Disclosure

The present disclosure relates to a display device and a method of fabricating the same.

### 2. Description of the Related Art

Wearable devices in the form of glasses or helmets present images a short distance in front of user's eyes. For example, a wearable device may be a head mounted display (HMD) device or an AR glass. Such a wearable device provides a user with an augmented reality (hereinafter referred to as "AR") screen or a virtual reality (hereinafter referred to as "VR") screen.

A wearable device such as a HMD device and AR glasses require display specifications of at least 2,000 PPI (pixels per inch) to allow users to use it for a long time without dizziness. To this end, organic light-emitting diode on silicon (OLEDoS) technology is emerging, which is high-resolution small organic light-emitting element display device. The OLEDoS is a technology for disposing organic light-emitting diodes (OLEDs) on a semiconductor wafer substrate on which a complementary metal oxide semiconductor (CMOS) is disposed.

In a display panel employing OLEDoS technology, leakage current may occur between adj acent pixels because of the short distance between pixels. Leakage current may be generated through some of conductive layers that are disposed between a pixel electrode (e.g., anode electrode) and a common electrode (e.g., cathode electrode). Such leakage current can cause undesirable color crosstalk between adjacent pixels.

### SUMMARY

Aspects of the present disclosure provide a display device in which at least some of an intermediate layer disposed between a pixel electrode and a common electrode are disconnected between adjacent pixels to prevent leakage current and color crosstalk, and a method of fabricating the same.

According to an embodiment of the present disclosure, a display device includes a substrate, a driver element layer disposed on the substrate, a line layer disposed on the driver element layer and including a first inorganic layer and a second inorganic layer disposed on the first inorganic layer, and a light-emitting element layer disposed on the line layer and including a plurality of first electrodes, an intermediate layer, and a second electrode sequentially stacked on one another. The line layer includes a trench between the first electrodes, the trench being free of the first inorganic layer and the second inorganic layer. The first inorganic layer includes an undercut area under the second inorganic layer in the trench. A first portion of the intermediate layer and a second portion of the second electrode are disposed in the trench. The first portion of the intermediate layer is disconnected from a third portion of the intermediate layer disposed on the first electrodes, and the second portion of the second electrode is connected to a fourth portion of the second electrode that overlaps the first electrodes.

The trench may include a first hole in which the second inorganic layer is removed with a first width, and a second hole in which the first inorganic layer is removed with a second width greater than the first width, the second hole including the undercut area that extends beyond the sidewall of the first hole.

At least some of conductive layers of the intermediate layer may be disconnected at by the trench.

The second electrode may be continuously disposed across the trench.

The at least some conductive layer comprise at least one layer of a hole injection layer (HIL), a hole transport layer (HTL), an electron transport layer (ETL), a charge generation layer (CGL), and a p-doped layer (PHIL).

The line layer may include an auxiliary line disposed in line with the trench, and the auxiliary line may be electrically connected to the first portion of the intermediate layer disposed on a bottom surface of the trench through a contact hole penetrating at least a portion of the line layer at the bottom surface of the trench.

A ground voltage may be supplied to the auxiliary line.

An auxiliary voltage lower than a voltage for driving a plurality of pixels may be applied to the auxiliary line.

The light-emitting element layer may be configured to emit white light.

The light-emitting element layer emits light of a first color in a first emission area associated with a first pixel, emits light of a second color in a second emission area associated with a second pixel, and emits light of a third color in a third emission area associated with a third pixel.

According to an embodiment of the present disclosure, a display device includes a substrate, a driver element layer disposed on the substrate, a line layer disposed on the driver element layer and including a first inorganic layer and a second inorganic layer disposed on the first inorganic layer, and a light-emitting element layer disposed on the line layer and including a plurality of first electrodes, a dummy inorganic film surrounding the plurality of first electrodes, an intermediate layer covering the plurality of first electrodes and the dummy inorganic film, a second electrode covering the intermediate layer. The line layer includes a trench between the first electrodes adjacent to each other, the first inorganic layer or the second inorganic layer being removed from the trench. The dummy inorganic film is formed on side surfaces of the trench, and a thickness of the dummy inorganic film formed on upper parts of the side surfaces of the trench is greater than a thickness of the dummy inorganic film formed on lower parts of the side surfaces of the trench. A first portion of the intermediate layer and a second portion of the second electrode are disposed on the dummy inorganic film in the trench, and the first portion of the intermediate layer is disconnected from a third portion of the intermediate layer disposed on the first electrodes, and the second portion of the second electrode is continuously connected to a fourth portion of the second electrode disposed to overlap the plurality of first electrodes.

A width of the trench has an inverted tapered shape as a thickness of the dummy inorganic film covering side surfaces of the trench decreases from an inlet of the trench to a bottom surface of the trench.

At least some of conductive layers of the intermediate layer may be disconnected by the trench.

The second electrode may be continuously disposed across the trench.

The at least some conductive layer comprise at least one layer of a hole injection layer (HIL), a hole transport layer (HTL), an electron transport layer (ETL), a charge generation layer (CGL), and a p-doped layer (PHIL).

According to an embodiment of the present disclosure, a method of fabricating a display device includes forming a driver element layer on a substrate, forming a line layer on the driver element layer, the line layer including a first inorganic layer and a second inorganic layer disposed on the first inorganic layer, and forming a light-emitting element layer on the line layer. The forming the light-emitting element layer includes forming a plurality of first electrodes on the second inorganic layer, forming a first trench having a first width by removing the second inorganic layer between adjacent first electrodes, forming a second trench having a second width greater than the first width by overly etching the first inorganic layer in the first trench, depositing an intermediate layer to cover the plurality of first electrodes, the second inorganic layer, and the first and second trenches, and depositing a second electrode to cover the intermediate layer. The intermediate layer is disconnected around the first trench and the second trench in the depositing the intermediate layer.

The second electrode may be not disconnected around the first trench and the second trench but may be continuously connected in depositing the second electrode.

The light-emitting element layer may be configured to emit white light.

The light-emitting element layer emits light of a first color in a first emission area associated with a first pixel, emits light of a second color in a second emission area associated with a second pixel, and emits light of a third color in a third emission area associated with a third pixel.

The substrate may include a semiconductor wafer substrate.

According to an embodiment of the present disclosure, a display device includes a substrate, a driver element layer disposed on the substrate, a line layer disposed on the driver element layer and including a first inorganic layer and a second inorganic layer disposed on the first inorganic layer, and a light-emitting element layer disposed on the line layer and including a plurality of first electrodes, an intermediate layer, and a second electrode sequentially stacked on one another. The line layer includes a trench between the adjacent first electrodes in which the first inorganic layer or the second inorganic layer are removed. A first portion of the intermediate layer is disposed in the trench, and an auxiliary line is electrically connected to the first portion of the intermediate layer.

A width of the trench has an inverted tapered shape as a thickness of the dummy inorganic film covering side surfaces of the trench decreases from an inlet of the trench to a bottom surface of the trench.

At least some of conductive layers of the intermediate layer may be disconnected at a boundary of the trench.

At least some of the above and other features of the invention are set out in the claims.

According to the embodiments of the present disclosure, it is possible to prevent leakage current and color crosstalk in a display device by way of disconnecting at least some of an intermediate layer disposed between a pixel electrode and a common electrode between adjacent pixels.

However, aspects of the present disclosure are not restricted to those set forth herein. The above and other aspects of the present disclosure will become more apparent to one of ordinary skill in the art to which the present disclosure pertains by referencing the detailed description of the present disclosure given below.

### BRIEF DESCRIPTION OF THE DRAWINGS

The above and other aspects and features of the present disclosure will become more apparent by describing in detail embodiments thereof with reference to the attached drawings, in which:
FIG. 1 is a perspective view showing a display device according to an embodiment of the present disclosure.
FIG. 2 is a plan view showing a display panel according to an embodiment.
FIG. 3 is a block diagram showing a display device according to an embodiment.
FIG. 4 is a circuit diagram of a pixel of a display device according to an embodiment of the present disclosure.
FIG. 5 is a cross-sectional view showing a portion of a display panel of a display device according to an embodiment of the present disclosure.
FIG. 6 is a cross-sectional view showing a stacked structure of a light-emitting element according to an embodiment of the present disclosure.
FIG. 7 is a cross-sectional view showing a stacked structure of a light-emitting element according to an embodiment of the present disclosure.
FIG. 8 is a plan view schematically showing a portion of a display area of a display panel according to an embodiment
FIG. 9 is a plan view showing a modification of the shape of the first electrodes shown in FIG. 8.
FIG. 10 is a plan view schematically showing a portion of a display area of a display panel according to an embodiment
FIG. 11 is a plan view showing a modification of the shape of the first electrodes shown in FIG. 10.
FIG. 12 is a cross-sectional view for illustrating a trench formed between adjacent pixels.
FIGS. 13 and 14 are cross-sectional views for illustrating processes of forming a trench according to an embodiment.
FIG. 15 is a cross-sectional view for illustrating a process of depositing an intermediate layer and a second electrode according to an embodiment.
FIG. 16 is a cross-sectional view for illustrating another shape of a trench formed between adjacent pixels.
FIGS. 17 to 19 are cross-sectional views for illustrating processes of forming a trench according to an embodiment.
FIG. 20 is a cross-sectional view for illustrating a process of depositing an intermediate layer and a second electrode according to an embodiment.
FIGS. 21 and 22 are cross-sectional views showing a display panel including an auxiliary line according to an embodiment.
FIG. 23 is a view showing an example of a wearable device including a display device according to an embodiment of the present disclosure.

### DETAILED DESCRIPTION OF THE EMBODIMENTS

The present inventive concept will now be described more fully with reference to the accompanying drawings, in which example embodiments are shown. These embodiments may be embodied in different forms and should not be construed as limited to the example embodiments set forth herein. Rather, these embodiments are provided so that this disclosure will be thorough and complete, and will fully convey the scope of the inventive concept to those skilled in the art.

It will also be understood that when a layer is referred to as being "on" another layer or substrate, it can be directly on the other layer or substrate, or intervening layers may also be present. The same reference numbers indicate the same components throughout the specification.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the present invention. Similarly, the second element could also be termed the first element.

Features of each of various embodiments of the present disclosure may be partially or entirely combined with each other and may technically variously interwork with each other, and respective embodiments may be implemented independently of each other or may be implemented together in association with each other.

Hereinafter, specific embodiments will be described with reference to the accompanying drawings.

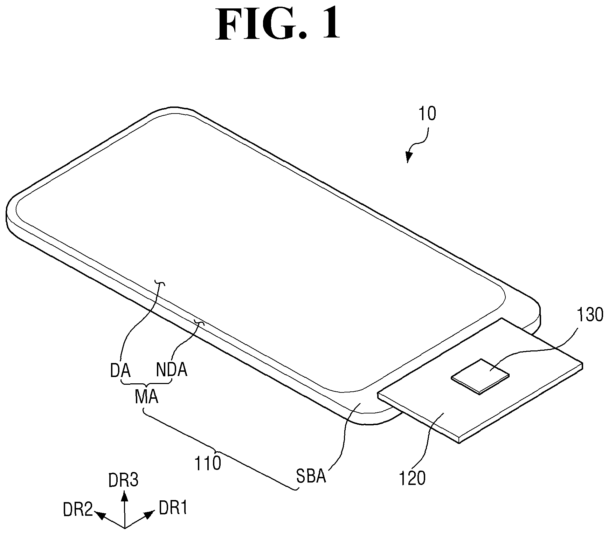

FIG. 1 is a perspective view showing a display device according to an embodiment of the present disclosure.

Referring to FIG. 1, a display device 10 may be employed by portable electronic devices such as a mobile phone, a smart phone, a tablet PC, a mobile communications terminal, an electronic notebook, an electronic book, a portable multimedia player (PMP), a navigation device and an ultra mobile PC (UMPC). For example, the display device 10 may be used as a display unit of a television, a laptop computer, a monitor, an electronic billboard, or the Internet of Things (IOT). For another example, the display device 10 may be applied to wearable devices such as a smart watch, a watch phone, a glasses-type display, and a head-mounted display (HMD) device.

The display device 10 may have a shape similar to a quadrangular shape when viewed from the top. For example, the display device 10 may have a shape similar to a rectangle having shorter sides in a first direction DR1 and longer sides in a second direction DR2. Alternatively, the display device 10 may have a shape similar to a rectangle having longer sides in the first direction DR1 and shorter sides in the second direction DR2. In FIG. 1, a third direction DR3 refers to a normal direction perpendicular to a plane defined by the first and second directions DR1 and DR2. The corners where the shorter sides and the longer sides meet may be rounded to have a predetermined curvature or may be formed at a right angle. The display device 10, when viewed from the top, is not limited to a quadrangular shape, but may have a shape similar to other polygonal shapes, a circular shape, or an elliptical shape.

The display device 10 may include a display panel 110, a circuit board 120 and a power supply unit 130.

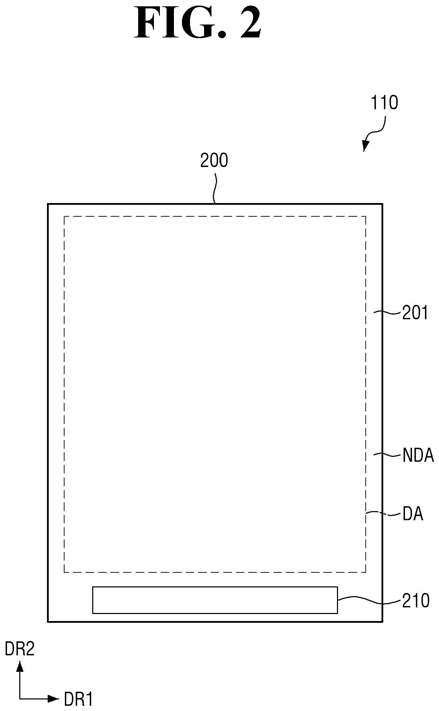

The display panel 110 uses a semiconductor wafer substrate 200 (see FIG. 2) as a base substrate. The display panel 110 may include a main area MA and a subsidiary area SBA.

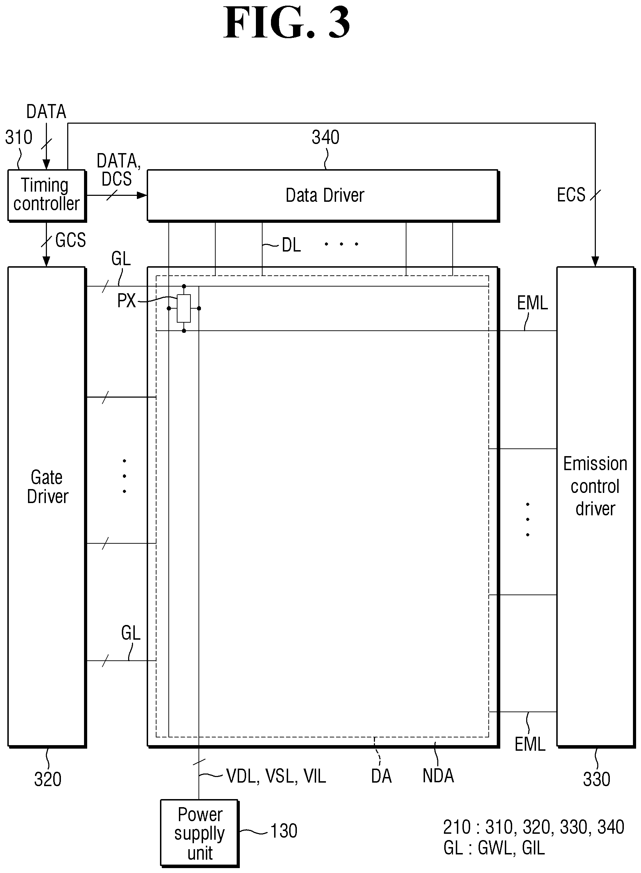

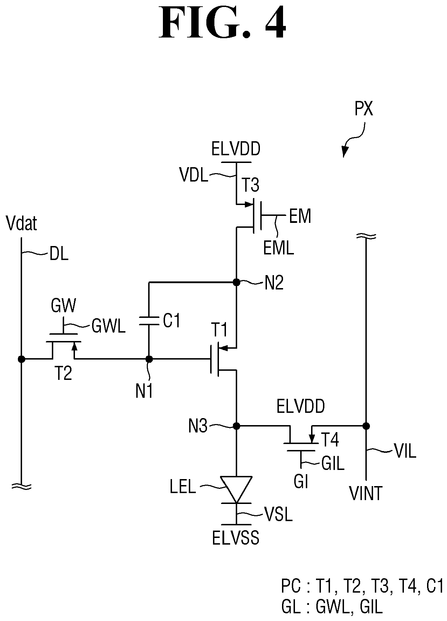

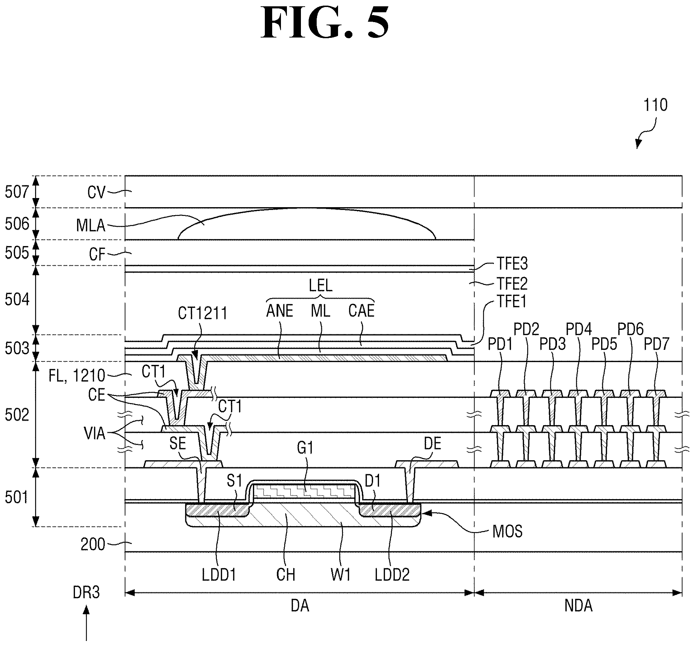

The main area MA may include a display area DA having pixels PX (see FIG. 3) for displaying images, and a non-display area NDA located around the display area DA. The non-display area NDA may refer to the area outside of the display area DA. The display area DA may output lights from a plurality of emission areas or a plurality of open areas. For example, the display panel 110 may include a pixel driver circuit PC (see FIG. 4) including switching elements, and a light-emitting element LEL (see FIG. 5), which are self-luminous elements.

The light-emitting element LEL may include, but is not limited to, at least one of: an organic light-emitting diode including an organic emissive layer, a quantum-dot light-emitting diode (quantum LED) including a quantum-dot emissive layer, an inorganic light-emitting diode (inorganic LED) including an inorganic semiconductor, and a micro light-emitting diode (micro LED).

The non-display area NDA may be disposed on the outer side of the display area DA. The non-display area NDA may be defined as the edge area of the main area MA of the display panel 110. The non-display area NDA may include fan-out lines (not shown) extended from lines (e.g., gate lines, data lines, and emission control lines) of the display area DA, and display pads (not shown) connecting the fan-out lines with a display driver circuit 210.

The subsidiary area SBA may be extended from one side of the main area MA. The subsidiary area SBA may include a main pad area connected to the circuit board 120. Optionally, the subsidiary area SBA may be eliminated, and the main pad area may be located in the non-display area NDA.

The circuit board 120 may be attached on the main pad area of the display panel 110 using an anisotropic conductive film (ACF). Lead lines of the circuit board 120 may be electrically connected to the main pad area of the display panel 110. The circuit board 120 may be a flexible printed circuit board (FPCB), a printed circuit board (PCB), or a flexible film such as a chip-on-film (COF).

The power supply unit 130 may be disposed on the circuit board 120 to apply supply voltages to the display driver circuit 210 and the display panel 110. The power supply unit 130 may generate supply voltages to provide them to the supply voltage lines. For example, the supply voltages may include a high-level voltage (first supply voltage ELVDD in FIG. 4), a low-level voltage (second supply voltage ELVSS in FIG. 4), and an initialization voltage VINT (see FIG. 4) for driving the light-emitting elements LEL.

FIG. 2 is a plan view showing a display panel according to an embodiment.

Referring to FIG. 2, the display panel 110 may be an OLEDoS (Organic Light Emitting Diode on Silicon) panel using the semiconductor wafer substrate as a base substrate. For example, the display panel 110 may include a substrate 200, and the substrate 200 may be a semiconductor wafer substrate. Herein, the substrate may be referred to as, but is not limited to, a semiconductor substrate, a semiconductor wafer substrate, or a wafer.

According to an embodiment, a pixel driver circuit PC (see FIG. 4) and a display driver circuit 210 controlling the pixel driver circuit PC may be disposed on a front surface 201 of the substrate 200. The pixel driver circuit PC is disposed to overlap the light-emitting element LEL (see FIG. 5) of the pixel PX (see FIG. 3) in the display area DA. The display driver circuit 210 is disposed in the non-display area NDA and drives the pixel driving circuits PC.

The pixel driver circuit PC (see FIG. 4) and the display driver circuit 210 may be formed in a driver element layer 501 (see FIG. 5) disposed on the front surface 201 of the substrate 200. The driver element layer 501 may include, for example, an n-type metal oxide semiconductor field effect transistor (MOSFET) and/or a p-type MOSFET. Herein, the driver element layer 501 (see FIG. 5) may be referred to as, but is not limited to, a MOSFET layer, a CMOS layer, a transistor layer, or a backplane layer, etc.

FIG. 3 is a block diagram showing a display device according to an embodiment.

Referring to FIG. 3, the display device 10 includes the display driver circuit 210 incorporated into the display panel 110. The display driver circuit 210 is formed on the driver element layer 501 disposed on the front surface of the substrate 200. The display driver circuit 210 may include, but is not limited to, a timing controller 310, a gate driver 320, an emission control driver 330, and a data driver 340. Although not shown in the drawings, the display driver circuit 210 may further include a memory (e.g., an OTP), an interface circuit (e.g., I/F), an image processing circuit (e.g., logic), and/or a gamma correction circuit.

The display area DA of the display panel 110 includes a plurality of pixels PX arranged in a matrix. Each of the plurality of pixels PX may be connected to a first supply voltage line VDL, a second supply voltage line VSL, a gate line GL, an emission control line EML, an initialization line VIL and a data line DL.

The first supply voltage line VDL supplies the first supply voltage ELVDD (see FIG. 4) input from the power supply unit 130 to the plurality of pixels PX. The second supply voltage line VSL supplies the second supply voltage ELVSS (see FIG. 4) input from the power supply unit 130 to the plurality of pixels PX. The gate line GL supplies the gate signals GI and GW (see FIG. 4) input from the gate driver 320 to the plurality of pixels PX. The emission control line EML supplies an emission control signal EM input from the emission control driver 320 to the plurality of pixels PX. The initialization line VIL supplies the initialization voltage VINT (see FIG. 4) input from the power supply unit 130 to the plurality of pixels PX. The data line DL provides analog data voltages input from the data driver 340 to the pixels PX.

The first supply voltage ELVDD may be a high-level voltage, and the second supply voltage ELVSS may be a low-level voltage. For example, the first supply voltage ELVDD may have a higher voltage level than the second supply voltage ELVSS. The initialization voltage VINT (see FIG. 4) may have a potential for initializing the pixel driver circuit PC (see FIG. 4) every frame.

One gate line GL shown in FIG. 3 may include, but is not limited to, a first gate line GWL and a second gate line GCL.

Each of the plurality of pixels PX may include a light-emitting element LEL (see FIG. 4), and a plurality of transistors and at least one capacitor as a pixel driver circuit PC (see FIG. 4) for driving the light-emitting element LEL.

The timing controller 310 may receive data signals DATA and timing signals from the circuit board 120. The timing controller 310 may control the operation timing of the data driver 340 by generating a data control signal DCS based on the timing signals. The timing controller 310 may control the operation timing of the gate driver 320 by generating a gate control signal DCS based on the timing signals. The timing controller 310 may control the operation timing of the emission control driver 330 by generating an emission control signal ECS based on the timing signals.

The data driver 340 may convert the data signal DATA into analog data voltages and may provide the converted analog data voltages to the pixels PX through the data lines DL. The gate signals from the gate driver 320 may be used to select pixels PX to which a data voltage is applied, and the selected pixels PX may receive the data voltage through the data lines DL.

The power supply unit 130 may be disposed on the circuit board 120 to apply supply voltages to the display driver circuit 210 and the display panel 110. The power supply unit 130 may generate supply voltages to provide them to the supply voltage lines VDL. The power supply unit 130 may generate a common voltage to provide it to a second electrode (e.g., the second electrode CAE of FIG. 5) commonly connected to the light-emitting elements LEL of a plurality of pixels.

The gate driver 310 may provide gate signals GI and GW (see FIG. 4) to the pixels PX through the gate lines GL.

The emission control driver 320 may provide an emission control signal EM (see FIG. 4) to the pixels PX through the emission control lines EML.

FIG. 4 is a circuit diagram of a pixel of a display device according to an embodiment of the present disclosure.

Referring to FIG. 4, a pixel PX may include a light-emitting element LEL (e.g., an organic light-emitting diode) as a display element and a pixel driving circuit PC connected to the light-emitting element LEL. The pixel driver circuit PC may include, but is not limited to, first to fourth transistors T1, T2, T3 and T4, and a first capacitor C 1. The first to fourth transistors T1, T2, T3 and T4 may be implemented as n-type metal oxide semiconductor field effect transistors (MOSFETs) and/or p-type MOSFETs. Although the first to fourth transistors T1, T2, T3 and T4 are p-type MOSFETs in the example shown in FIG. 4, the present disclosure is not limited thereto.

The first transistor T1 may be a driving transistor in which a source-drain current is determined depending on a gate-source voltage. Each of the second to fourth transistors T2 to T4 may be a switching transistor that is turned on/off depending on a gate-source voltage, substantially a gate voltage.

The first transistor T1 includes a gate electrode connected to a first node N1, a source electrode connected to a second node N2, and a drain electrode connected to a third node N3. The first transistor T1 is turned on or off based on the voltage level of the first node N1. In the turned-on state, the first transistor T1 connects the second node N2 to the third node N3. The second node N2 is connected to a source electrode of the third transistor T3 and is supplied with the first supply voltage ELVDD when the third transistor T3 is turned on in response to the emission control signal EM. The third node N3 is connected to a first electrode ANE (see FIG. 5) of the light-emitting element LEL and a drain electrode of the fourth transistor T4. The third node N3 is supplied with the initialization voltage VINT when the fourth transistor T4 is turned on in response to the second gate signal GI.

The second transistor T2 includes a gate electrode connected to the first gate line GWL, a source electrode connected to the data line, and a drain electrode connected to the first node N1. The second transistor T2 is turned on in response to the first gate signal GW supplied from the first gate line GWL. The turned-on second transistor T2 provides a data signal Vdat from the data line to the first node N1.

The third transistor T3 includes a gate electrode connected to the emission control line EML, a source electrode connected to the first supply voltage line VDL from which the first supply voltage ELVDD is supplied, and a drain electrode connected to the second node N2. The third transistor T3 is turned on in response to the emission control signal EM supplied from the emission control line EML. In the turned-on state, the third transistor T3 provides the first supply voltage ELVDD to the second node N2.

The fourth transistor T4 includes a gate electrode connected to the second gate line GIL, a source electrode connected to the initialization line VIL from which the initialization voltage VINT is supplied, and a drain electrode connected to the third node N3. The fourth transistor T4 is turned on in response to the second gate signal GI supplied from the second gate line GIL. The turned-on fourth transistor T4 provides the initialization voltage VINT to the third node N3.

The first capacitor C1 is disposed between the first node N1 and the second node N2. The first capacitor C 1 may store the data signal Vdat input through the second transistor T2.

The light-emitting element LEL may include a first electrode (e.g., the first electrode ANE of FIG. 5), a second electrode facing the first electrode (e.g., the second electrode CAE of FIG. 5), and an intermediate layer disposed between the first electrode and the second electrode. The intermediate layer may include an organic light-emitting layer. The second electrode may receive the second supply voltage ELVSS. The second electrode may be connected to the second supply voltage line VSL transmitting the second supply voltage ELVSS. The second electrode may be commonly connected to a plurality of pixels PX.

FIG. 5 is a cross-sectional view showing a portion of the display panel 110 of the display device 10 according to the embodiment. For example, FIG. 5 is a view schematically showing a stack structure of each of the non-display area NDA and the display area DA of the display panel 100 according to the embodiment.

In the description with reference to FIG. 5, an element disposed "on" the substrate 200 may mean that the element is disposed on the front surface of the substrate 200 in the third direction DR3. The front surface of the substrate 200 may refer to the side on which the light-emitting elements LEL disposed in the display area DA emit light for displaying an image.

Referring to FIG. 5, the display panel 110 according to the embodiment includes the substrate 200, and the substrate 200 may be a semiconductor wafer substrate.

The driver element layer 501 including a display driver circuit 210 and a pixel driver circuit PC, at least one line layer 502, a light-emitting element layer 503 including light-emitting elements LEL, an encapsulation layer 504 covering the light-emitting elements LEL, a color filter layer 505 including color filters CF, a light control layer 506 including a refractive film MLA, and a cover layer 507 including a cover member CV may be sequentially stacked on the front surface of the substrate 200. At least some of the light-emitting element layer 503, the encapsulation layer 504, the color filter layer 505, the light control layer 506 and the cover layer 507 may not be disposed in the non-display area NDA.

The substrate 200 may be a silicon substrate, a germanium substrate, or a silicon-germanium substrate. The substrate 200 may be a substrate doped with first-type impurities.

The driver element layer 501 including an n-type MOSFET and/or a p-type MOSFET is disposed on the substrate 200. The first-type impurities may be p-type impurities, while the second-type impurities may be n-type impurities. Alternatively, the first-type impurities may be n-type impurities, while the second-type impurities may be p-type impurities.

In the following description, an n-type MOSFET MOS included in the driver element layer 501 will be described as an example. The n-type MOSFET MOS may include a well W1 doped with n-type impurities in a substrate doped with p-type impurities.

The well W1 may include a first low-concentration impurity region LDD1 and a second low-concentration impurity region LDD2 having a relatively low impurity concentration than the other portions. The first low-concentration impurity region LDD1 may define a source region S1, and the second low-concentration impurity region LDD2 may define a drain region D1. The source electrode SE of the MOSFET MOS may be connected to the source region S1, and the drain electrode of the MOSFET MOS may be connected to the drain region D 1.

A channel CH overlapping a gate G1 is defined between the first low-concentration impurity region LDD 1 and the second low-concentration impurity region LDD2. An oxide film (not shown) may be disposed between the gate G1 and the well W1 as an insulating layer.

The MOSFETs MOS form the display driver circuit 210 (see FIG. 2), and the display driver circuit 210 is disposed in the non-display area NDA of the display panel 110. In addition, the MOSFETs MOS form the transistors T1, T2, T3 and T4 included in the pixel driver circuit PC, and the pixel driver circuits PC are disposed in the display area DA of the display panel 110. That is to say, each pixel driver circuit PC includes a combination of MOSFETs MOS disposed in the driver element layer 501 in the display area DA. In addition, the display driver circuit 210 includes a combination of MOSFETs MOS disposed in the driver element layer 501 in the non-display area NDA. In the example shown in FIG. 5, one MOSFET MOS of a pixel driver circuit PC disposed in the display area DA of the display panel 110 is shown for convenience of illustration.

At least one line layer 502 is disposed on the driver element layer 501. The at least one line layer 502 includes insulating layers VIA sequentially stacked on the driver element layer 501, and connection electrodes CE and lines (not shown) connected to the MOSFETs MOS through contact holes CT1 penetrating at least some of the insulating layers VIA. That is to say, the line layers 502 include the connection electrodes CE and connection lines that connect the MOSFETs MOS of the driver element layer 501 with one another, and the insulating layers VIA for insulating them from one another. In addition, the line layers 502 may include a plurality of signal lines for driving the display panel 110 and a plurality of power lines.

The connection electrodes CE shown in FIG. 5 connect some MOSFETs MOS associated with the pixel driver circuit PC among the plurality of MOSFETs MOS disposed in the driver element layer 501 with the light-emitting elements LEL disposed on the line layer 502 in a vertical direction. Herein, the vertical direction refers to the normal direction DR3 of the display panel 110.

Lines (not shown) disposed in the line layer 502 include lines (e.g., the lines GL, DL and EML in FIG. 3) connected to the pixel driver circuit PC. The lines disposed in the line layer 502 may further include fan-out lines (not shown) that are disposed in the non-display area NDA and extended from the lines (e.g., the lines GL, DL and EML of FIG. 3) connected to the pixel driver circuits PC.

The line layer 502 may include pad electrodes PD1, PD2, PD3, PD4, PD5, PD6 and PD7 disposed in the non-display area NDA. The pad electrodes PD1, PD2, PD3, PD4, PD5, PD6 and PD7 may include a first gate pad PD1 connected to the first gate line GWL, a second gate pad PD2 connected to the second gate line GIL, an initialization pad PD3 connected to the initialization line VIL, an emission pad PD4 connected to the emission control line EML, a data pad PD5 connected to the data line DL, a first driving voltage pad PD6 connected to the first supply voltage line VDL, and a second driving voltage pad PD7 connected to the second supply voltage line VSL. It should be noted that the pad electrodes PD1, PD2, PD3, PD4, PD5, PD6 and PD7 shown in FIG. 5 are merely illustrative, and the present disclosure is not limited thereto.

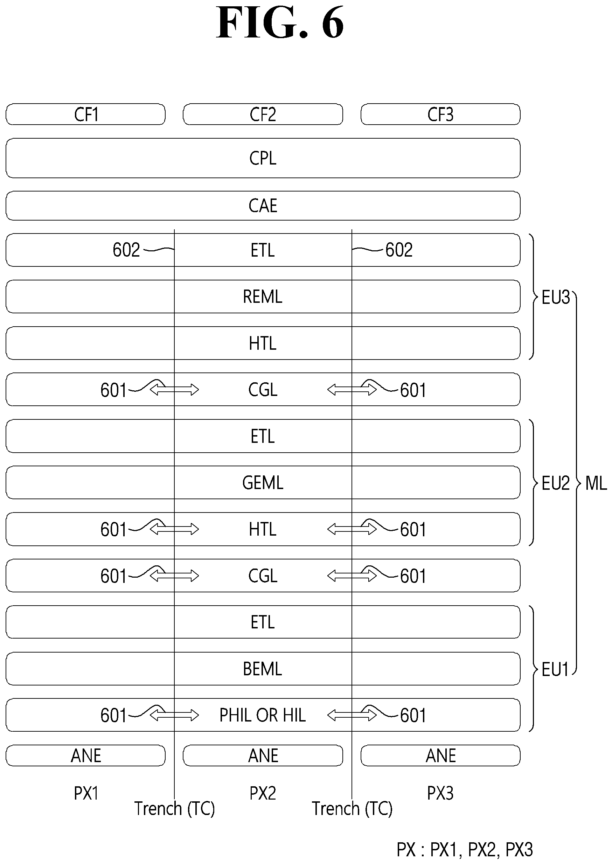

In the uppermost layer of the insulating layers VIA included in the line layer 502, a planarization layer FL including an organic film, and a plurality of inorganic layers 1210 disposed on the planarization layer FL may be disposed. As will be described later with reference to FIGS. 6 to 20, the inorganic layers 1210 are partially removed between adjacent pixels PX, so that trenches TC are formed. Due to the trenches TC, the intermediate layer ML of the light-emitting elements LEL is disconnected between adjacent pixels PX during a process of depositing the intermediate layer ML of the light-emitting elements LEL. According to the embodiment, it is possible to prevent leakage current between adjacent pixels PX and to prevent color crosstalk by disconnecting the intermediate layer ML of the light-emitting elements LEL between the adjacent pixels PX. The color crosstalk refers to, for example, a phenomenon that a red pixel (e.g., a first pixel PX1) adjacent to a blue pixel (e.g., a third pixel PX3) is unintentionally turned on while the blue pixel (e.g., the third pixel PX3) emits blue light. Since color crosstalk occurs due to leakage current, it may occur if a blue pixel and a red pixel are adjacent to each other, which have a large difference in voltage for driving the pixels. For example, while the driving current is supplied to the light-emitting element LEL of a blue pixel in order to turn on the blue pixel, a part of the driving current may be transmitted to a red pixel (e.g., a first pixel PX1) through at least some conductive layers of the intermediate layer ML, which is leakage current. If leakage current is generated, the red pixel may be unintentionally turned on while the blue pixel is turned on.

The light-emitting element layer 503 including a light-emitting element LEL may be disposed on the line layer 502. A light-emitting element LEL includes a first electrode ANE connected to a MOSFET MOS included in a pixel driver circuit PC through a contact hole CT1211 and a connection electrode CE, an intermediate layer ML disposed on the first electrode ANE, and a second electrode CAE disposed on the intermediate layer ML.

The intermediate layer ML may include, but is not limited to, a hole injection layer HIL, a hole transport layer HTL, an emissive layer, an electron transport layer ETL, and an electron injection layer EIL. For example, the light-emitting element LEL may be a RGB-type light-emitting element LEL that emits a first color light (e.g., red light) in the first pixel PX1 (e.g., a red pixel); a second color light (e.g., green light) in the second pixel PX2 (e.g., green pixel); and a third color light (e.g., blue light) in the third pixel PX3 (e.g., blue pixel). Alternatively, the light-emitting element LEL may be a WOLED emitting white light equally in the first pixel PX1 (e.g., a red pixel), the second pixel PX2 (e.g., a green pixel), and the third pixel PX3 (e.g., a blue pixel)..

A stacked structure of organic materials included in the intermediate layer ML may have different structures depending on whether the light-emitting elements LEL are RGB-type light-emitting elements or WOLEDs (white OLEDs). It should be understood, however, that the present disclosure is not limited thereto.

An encapsulation layer 504 including at least one organic encapsulation layer and at least one inorganic encapsulation layer may be disposed on the light-emitting element layer 503. For example, the encapsulation layer 504 may include, but is not limited to, a first inorganic encapsulation film TFE1, an organic encapsulation film TFE2, and a second inorganic encapsulation film TFE3.

The color filter layer 505 including color filters CF may be disposed on the encapsulation layer 504. The color filter CF may include, but is not limited to, a first color filter CF1 that transmits red light, a second color filter CF2 that transmits green light, and a third color filter CF3 that transmits blue light. The color filter layer 505 may be disposed in a display device where the light-emitting elements LEL of the light-emitting element layer 503 are WOLEDs. If the light-emitting elements LEL of the light-emitting element layer 503 emit red light, green light and blue light on their own, the color filter layer 505 may be omitted.

The light control layer 506 including the refractive film MLA is disposed on the color filter layer 505. The refractive film MLA may refract light incident thereon so that lights emitted from the light-emitting element layer 503 are directed toward the normal direction DR3 of the display panel 110. The refractive film MLA may include a micro lens array.

The cover layer 507 serving as a cover for the display panel 110 may be disposed on the light control layer 506. The cover layer 507 may include, but is not limited to, a cover member CV made of glass material. The cover layer 507 may include, for example, a protective film.

FIG. 6 is a cross-sectional view schematically showing a stacked structure of light-emitting elements according to an embodiment. For example, in a stacked structure of an intermediate layer ML shown in FIG. 6, light-emitting elements LEL of a light-emitting element layer 503 are WOLEDs.

Referring to FIG. 6, the display panel 110 according to the embodiment may include a plurality of pixels PX including a first pixel PX1 for displaying a first color (e.g., red), a second pixel PX2 for displaying a second color (e.g., green), and a third pixel PX3 for displaying a third color (e.g., blue).

The light-emitting elements LEL disposed in the first pixel PX1, the second pixel PX2 and the third pixel PX3 emit white light. The display panel 110 displays the first color, the second color and the third color using the color filters. For example, the white light emitted from the first pixel PX1 is converted into the first color through the first color filter CF1, the white light emitted from the second pixel PX2 is converted into the second color through the second color filter CF2, and the white light emitted from the third pixel PX3 is converted into the third color through the third color filter CF3.

A first electrode ANE (e.g., a pixel electrode or an anode electrode) is disposed in each of the first pixel PX1, the second pixel PX2 and the third pixel PX3. The intermediate layer ML and the second electrode CAE are disposed on the first electrode ANE of each of the first pixel PX1, the second pixel PX2 and the third pixel PX3.

The intermediate layer ML and the second electrode CAE may be common layers that are commonly stacked in the first pixel PX1, the second pixel PX2 and the third pixel PX3 and connected to each other between the plurality of pixels PX at least partially.

The intermediate layer ML may include, but is not limited to, a first emission unit EU1, a charge generation layer CGL, a second emission unit EU2, a charge generation layer CGL and a third emission unit EU3 sequentially stacked on the first electrode ANE of each of the first pixel PX1, the second pixel PX2 and the third pixel PX3. That is to say, the order and structure of the layers of the intermediate layer ML may be altered in a variety of ways.

The first emission unit EU1 may include a hole injection layer HIL or a p-doped layer PHIL doped with a p-type semiconductor, a blue emissive layer BEML, and an electron transport layer ETL. The second emission unit EU2 may include a hole transport layer HTL, a green emissive layer GEML, and an electron transport layer ETL. The third emission unit EU3 may include a hole transport layer HTL, a red emissive layer REML, and an electron transport layer ETL.

The charge generation layer CGL is disposed between the first emission unit EU1 and the second emission unit EU2. In addition, the charge generation layer CGL may be disposed between the second emission unit EU2 and the third emission unit EU3. The charge generation layer CGL may include a negative charge generation layer and a positive charge generation layer.

The second electrode CAE is disposed on the third emission unit EU3. The second electrode CAE may be a common layer that is commonly stacked in the first pixel PX1, the second pixel PX2 and the third pixel PX3 and extended across the plurality of pixels PX at least partially.

The capping layer CPL may be disposed on the second electrode CAE. Although not shown in the drawings, the encapsulation layer 504 (see FIG. 5) may be disposed on the capping layer CPL, and the first color filter CF1, the second color filter CF2 and the third color filter CF3 may be disposed on the encapsulation layer 504. The capping layer CPL may be used to improve the emission efficiency by the principle of constructive interference.

In the display panel 110 according to the embodiment, as the intermediate layer ML disposed between the first electrode ANE and the second electrode CAE is commonly stacked in the first pixel PX1, the second pixel PX2 and the third pixel PX3, and are connected to each other between the plurality of pixels PX at least partially, leakage current may occur. As indicated by arrows 601 in FIG. 6, the leakage current may flow between adjacent pixels PX through at least some conductive layers included in the intermediate layer ML.

In the display panel 110 according to the embodiment, trenches TC are formed between the pixels PX to prevent leakage current. For example, the trenches TC are formed between the first electrodes ANE of adjacent pixels PX and are formed by removing a part of an inorganic layer included in the line layer 502. The trenches TC formed between adjacent pixels PX cause at least some conductive layers included in the intermediate layer ML to be disconnected during the process of depositing the intermediate layer ML. According to the embodiment of the present disclosure, as indicated by solid lines 602 in FIG. 6, at least some of the conductive layers included in the intermediate layer ML are disconnected around the trenches TC formed between the adjacent pixels PX, so that it is possible to prevent leakage current and color crosstalk. Herein, at least some conductive layers of the intermediate layer ML that are disconnected around the trenches TC may include at least one of: a hole injection layer HIL, a hole transport layer HTL, an electron transport layer ETL, a charge generation layer CGL, and a p-doped layer PHIL.

Even though the trenches TC are located between adjacent pixels PX, the metal of the second electrode CAE is not disconnected because it has step coverage superior to that of the organic materials forming the intermediate layer ML. Specifically, while the intermediate layer ML is disconnected around the trenches TC, the second electrode CAE is not disconnected around the trenches TC. Accordingly, the second electrode CAE may be continuously extended across adjacent pixels PX.

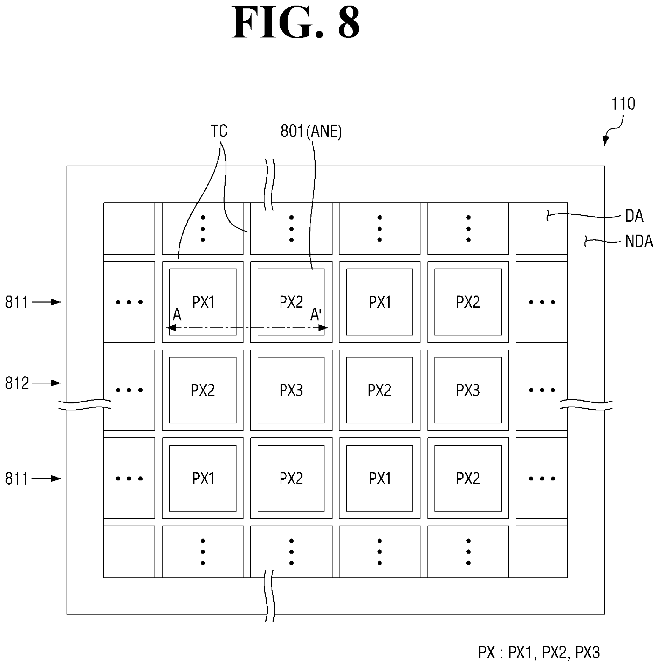

The structure of the trenches TC and the disconnection of the intermediate layer ML according to an embodiment of the present disclosure will be described later in detail with reference to FIGS. 8 to 22.

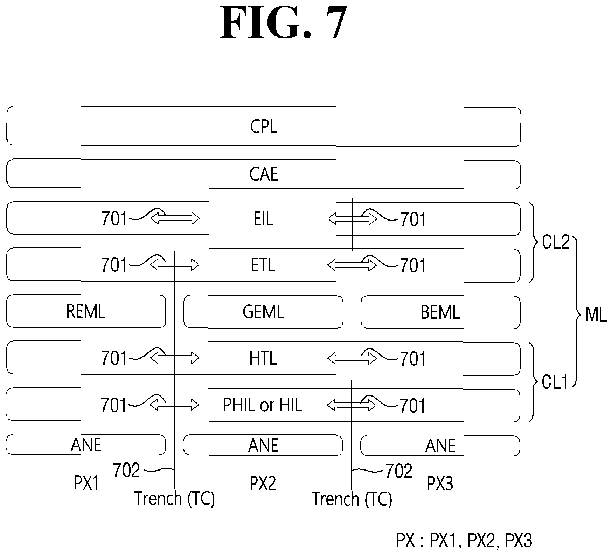

FIG. 7 is a cross-sectional view schematically showing a stacked structure of light-emitting elements according to an embodiment. For example, FIG. 7 shows a stacked structure of the intermediate layer ML of RGB-type light-emitting elements LEL that emit red light in a first pixel PX1; green light in a second pixel PX2; and blue light in a third pixel PX3 on their own.

Referring to FIG. 7, the display panel 110 according to the embodiment may include a plurality of pixels PX including a first pixel PX1 for displaying a first color (e.g., red), a second pixel PX2 for displaying a second color (e.g., green), and a third pixel PX3 for displaying a third color (e.g., blue).

Each of the first pixel PX1, the second pixel PX2 and the third pixel PX3 may emit light of a predetermined color on its own. For example, the light-emitting element LEL includes a red emissive layer REMI, to emit red light in a first emission area in the first pixel PX1, the light-emitting element LEL includes a green emissive layer GEML to emit green light in a second emission area in the second pixel PX1, and the light-emitting element LEL includes a blue emissive layer BEMI, to emit blue light in a third emission area in the third pixel PX3. In the first emission area, the first electrode ANE disposed in the first pixel PX1 may be covered by the intermediate layer ML. In the second emission area, the first electrode ANE disposed in the second pixel PX2 may be covered by the intermediate layer ML. In the third emission area, the first electrode ANE disposed in the third pixel PX3 may be covered by the intermediate layer ML.

The first electrode ANE (e.g., a pixel electrode or an anode electrode) is disposed in each of the first pixel PX1, the second pixel PX2 and the third pixel PX3. The intermediate layer ML and the second electrode CAE are disposed on the first electrode ANE of each of the first pixel PX1, the second pixel PX2 and the third pixel PX3. In the intermediate layer ML, a first common layer (e.g., lower common layer) CL1, an emissive layer, a second common layer (e.g., upper common layer) CL2, and a second electrode CAE are disposed.

The first common layer CL1, the second common layer CL2 and the second electrode CAE may be commonly stacked in the first pixel PX1, the second pixel PX2 and the third pixel PX3, and may be extended across the pixels PX at least partially. On the contrary, different emissive layers RMEL, GEML and BEMI, may be disposed between the first common layer CL1 and the second common layer CL2 in the first pixel PX1, the second pixel PX2 and the third pixel PX3, respectively. For example, the red emissive layer REML may be disposed in the first pixel PX1, the green emissive layer GEML may be disposed in the second pixel PX2, and the blue emissive layer BEMI, may be disposed in the third pixel PX3. They may be disconnected from one another at the boundaries of the pixels PX.

The first common layer CL1 may be disposed under the emissive layers RMEL, GEML and BEML, and may include, but is not limited to, a hole injection layer HIL or a p-doped layer PHIL doped with a p-type semiconductor and a hole transport layer HTL. For example, the first common layer CL1 may include at least one hole injection layer HIL and at least one hole transport layer HTL.

The second common layer CL2 may be disposed on the emissive layers RMEL, GEML and BEML, and may include, but is not limited to, an electron transport layer ETL and an electron injection layer EIL. For example, the second common layer CL2 may include at least one electron transport layer ETL and at least one electron injection layer EIL.

The capping layer CPL may be disposed on the second electrode CAE. The capping layer CPL may be used to improve the emission efficiency by the principle of constructive interference.

The embodiment of FIG. 7 includes no color filter unlike the embodiment of FIG. 6.

Like the embodiment of FIG. 6, in the display panel 110 according to the embodiment shown in FIG. 7, a first common layer CL1 and a second common layer CL2 disposed between a first electrode ANE and a second electrode CAE are commonly stacked in a first pixel PX1, a second pixel PX2 and a third pixel PX3 and are connected to one another between a plurality of pixels PX at least partially. Therefore, leakage current may be generated through the first common layer CL1 and the second common layer CL2. The leakage current may flow between adjacent pixels PX through at least some conductive layers included in the first common layer CL1 and the second common layer CL2, as indicated by arrows 701 in FIG. 7.

In the display panel 110 according to the embodiment, trenches TC are formed between the pixels PX to prevent leakage current. For example, the trenches TC are formed between the first electrodes ANE of adjacent pixels PX and are formed by removing a part of an inorganic layer included in the line layer 502. The trenches TC formed between adjacent pixels PX cause at least some conductive layers included in the intermediate layer ML to be disconnected during the process of depositing the intermediate layer ML. According to the embodiment of the present disclosure, as indicated by solid lines 702 in FIG. 7, at least some of the conductive layers included in the intermediate layer ML are disconnected around the trenches TC formed between the adjacent pixels PX, so that it is possible to prevent leakage current and color crosstalk. Herein, at least some conductive layers of the intermediate layer ML that are disconnected around the trenches TC may include at least one of: the hole injection layer HIL, the hole transport layer HTL, the electron transport layer ETL, and the electron injection layer EIL.

Even though the trenches TC are located between adjacent pixels PX, the metal of the second electrode CAE is not disconnected because it has step coverage superior to that of the organic materials forming the intermediate layer ML. Specifically, while the intermediate layer ML is disconnected around the trenches TC, the second electrode CAE is not disconnected around the trenches TC. Accordingly, the second electrode CAE may be continuously extended across adjacent pixels PX.

It is known that a driving voltage for driving a blue pixel is higher than a driving voltage for driving a red pixel. Therefore, leakage current and color crosstalk may occur between blue pixels and red pixels adjacent to each other. According to an embodiment, in order to prevent blue pixels and red pixels from being adjacent to each other, first pixels PX1 (e.g., red pixels), second pixels PX2 (e.g., green pixels) and third pixels PX3 (e.g., blue pixels) are arranged as shown in FIGS. 8 to 11.

FIG. 8 is a plan view schematically showing a portion of a display area of a display panel 110 according to an embodiment.

Referring to FIG. 8, the display panel 110 includes a plurality of pixels PX including first pixels PX1, second pixels PX2 and third pixels PX3. The pixels PX are arranged in a matrix in the display area DA of the display panel 110, such that the first pixels PX1 emitting red light and the third pixels PX3 emitting blue light are arranged adjacent to each other in diagonal directions. First pixels PX1 and second pixels PX2 are arranged alternately in each odd-numbered row 811, and second pixels PX2 and third pixels PX3 may be arranged alternately disposed in each even-numbered row 812. In addition, the first pixels PX1 disposed in the odd-numbered row 811 and the second pixels PX2 disposed in the even-numbered row 812 are disposed adjacent to each other in column direction (i.e., a vertical direction), and the second pixels PX2 disposed in the odd-numbered row 811 and the third pixels PX3 disposed in the even-numbered row 812 are disposed adjacent to each other in the column direction (i.e., the vertical direction). According to the embodiment of the present disclosure, leakage current and color crosstalk can be suppressed by arranging the first pixels PX1 and the third pixels PX3 such that they are located as far as possible.

According to an embodiment, trenches TC are formed between the pixels PX by removing some of inorganic layers included in the line layer 502. In FIG. 8, solid lines (e.g., lines 801 of FIG. 8) defining the first pixel PX1, the second pixel PX2 and the third pixel PX3 indicate the first electrodes ANE disposed in the first pixel PX1, the second pixel PX2 and the third pixels PX3, respectively. Therefore, the trenches TC according to the embodiment may be defined as being located between the first electrodes ANE of adjacent pixels PX.

According to an embodiment, as the pixels PX are arranged in a matrix, the trenches TC may be formed in a mesh topology to surround the first electrode ANE of the pixels PX.

At least some of the first pixels PX1, the second pixels PX2 and the third pixels PX3 shown in FIG. 8 may be replaced with fourth pixels emitting white light. For example, fourth pixels emitting white light and third pixels PX3 emitting blue light may be arranged alternately in each even-numbered row.

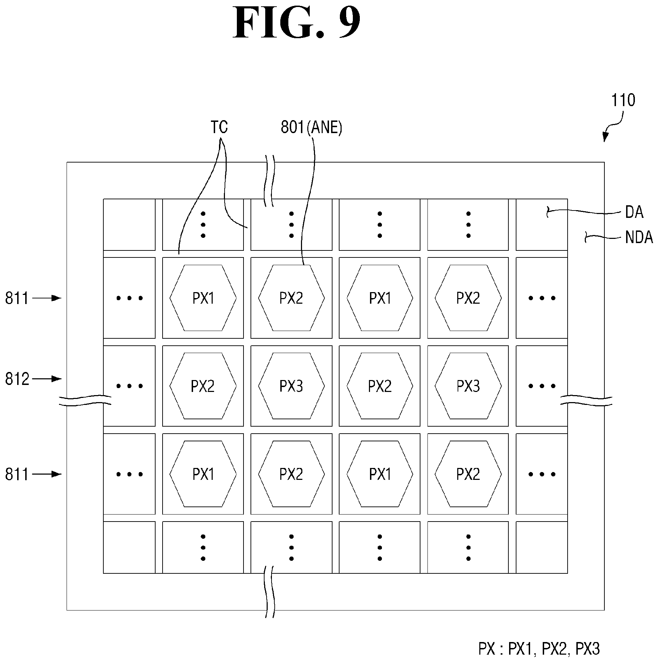

FIG. 9 is a plan view showing a modification of the shape of the first electrodes ANE shown in FIG. 8. The embodiment of FIG. 9 is substantially identical to the embodiment of FIG. 8 except that each first electrode ANE has a hexagonal shape when viewed from the top. That is to say, the display panel 110 according to embodiments of the present disclosure is not limited to having the first electrode ANE in a rectangular shape, but may have a hexagonal shape as shown in FIG. 9.

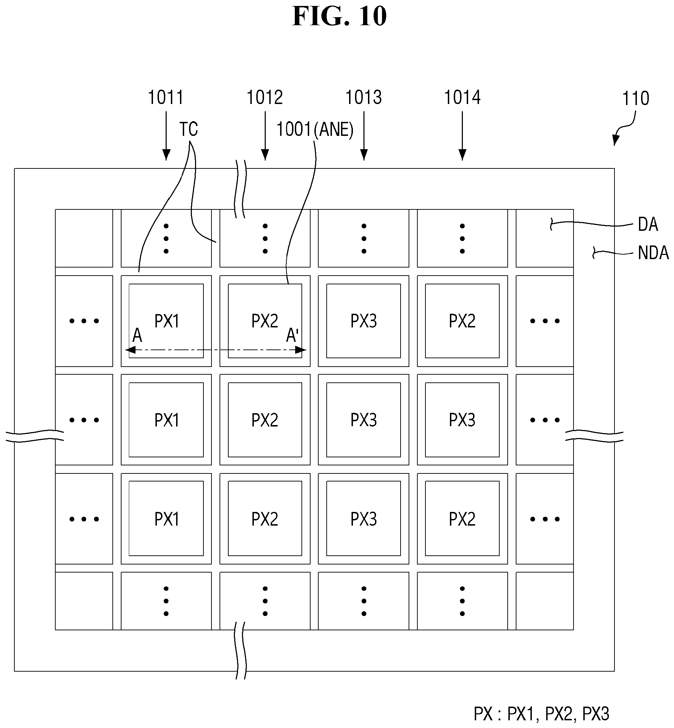

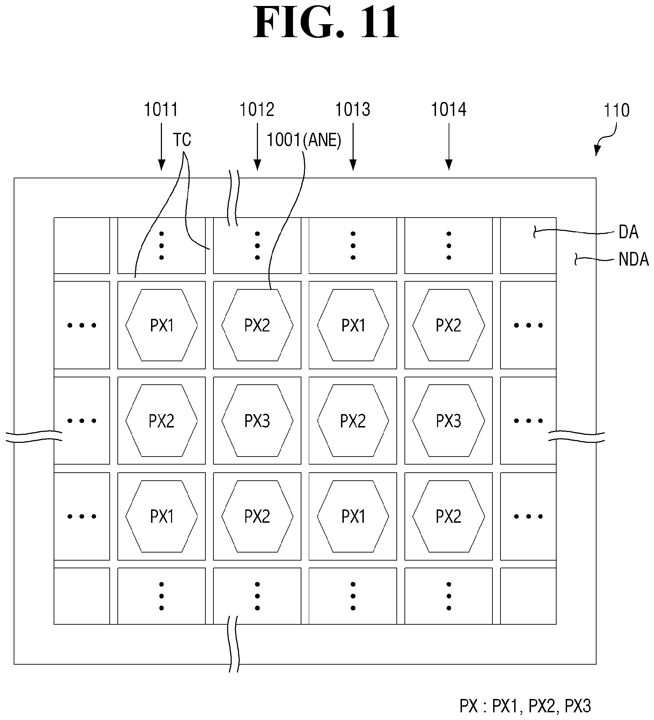

FIG. 10 is a plan view schematically showing a portion of a display area of a display panel 110 according to an embodiment. FIG. 11 is a plan view showing a modification of the shape of the first electrodes ANE shown in FIG. 10.

Referring to FIG. 10, the display panel 110 includes a plurality of pixels PX including first pixels PX1, second pixels PX2 and third pixels PX3. The pixels PX are arranged in a matrix in the display area DA of the display panel 110, such that second pixels PX2 emitting green light are disposed between the first pixels PX1 emitting red light and the third pixels PX3 emitting blue light. For example, the first pixels PX1 are disposed in a first column 1011, the second pixels PX2 are disposed in a second column 1012, and the third pixels PX3 are disposed in a third column 1013. Accordingly, the first pixels PX1 disposed in the first column 1011 and the third pixels PX3 disposed in the third column 1013 are spaced apart from each other. Similarly, second pixels PX2 may be disposed in the fourth column 1014, and first pixels PX1 may be disposed in a fifth column (not shown). According to the embodiment of the present disclosure, leakage current and color crosstalk can be suppressed by arranging the first pixels PX1 and the third pixels PX3 such that they are located as far as possible.

According to an embodiment, trenches TC are formed between the pixels PX by removing some of inorganic layers included in the line layer 502. In FIG. 10, solid lines (e.g., lines 1001) defining the first pixel PX1, the second pixel PX2 and the third pixel PX3 indicate the first electrodes ANE disposed in the first pixel PX1, the second pixel PX2 and the third pixels PX3, respectively. Therefore, the trenches TC according to the embodiment may be defined as being located between the first electrodes ANE of adjacent pixels PX.

According to an embodiment, as the pixels PX are arranged in a matrix, the trenches TC may be formed in a mesh topology to surround the first electrode ANE of the pixels PX.

FIG. 11 is a plan view showing a modification of the shape of the first electrodes ANE shown in FIG. 10. The embodiment of FIG. 11 is substantially identical to the embodiment of FIG. 8 except that each first electrode ANE has a hexagonal shape when viewed from the top. That is to say, the display panel 110 according to embodiments of the present disclosure is not limited to having the first electrode ANE in a rectangular shape, but may have a hexagonal shape as shown in FIG. 11.

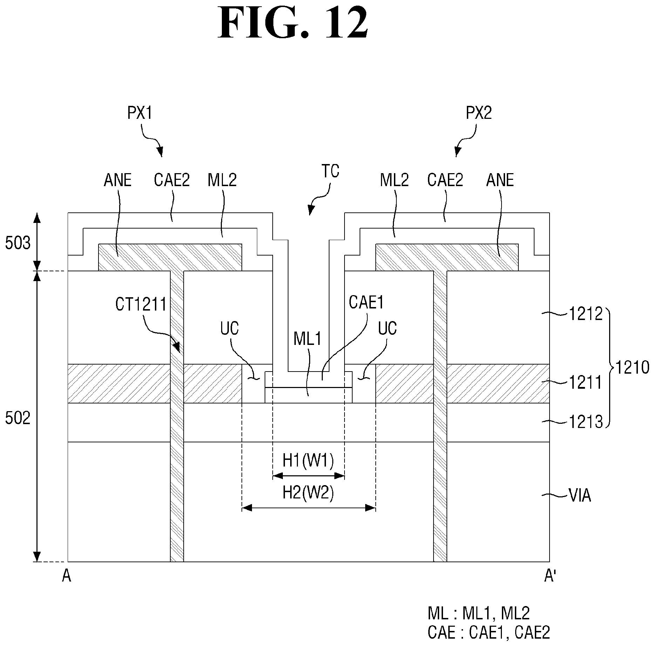

Features of the trenches TC according to embodiments will be described in detail with reference to FIGS. 12 to 22. The term trenches TC used herein may be interchangeably used with other similar terms. Although the features of the trenches TC according to the embodiment of FIG. 8 will be described in the following description with reference to FIGS. 12 to 22, such features of the trenches TC may also be applied to the embodiments of FIGS. 9 to 11.

FIG. 12 is a cross-sectional view for illustrating a trench TC formed between adjacent pixels PX. For example, FIG. 12 is a cross-sectional view of some layers of the line layer 502 and the light-emitting elements LEL, taken along line A - A' shown in FIGS. 8 and 10.

Referring to FIG. 12, the line layer 502 of the display panel 110 includes a first inorganic layer 1211 and a second inorganic layer 1212 disposed on the first inorganic layer 1211. For example, the first inorganic layer 1211 and the second inorganic layer 1212 may be in the uppermost layer of the line layer 502 and may be located at the boundary between the line layer 502 and the light-emitting element layer 503.

According to an embodiment, the first inorganic layer 1211 may include silicon nitride (SiNx), and the second inorganic layer 1212 may include silicon oxide (SiOx). A third inorganic layer 1213 made of the same material as the second inorganic layer 1212 may be further disposed under the first inorganic layer 1211. For example, the third inorganic layer 1213 may include silicon oxide (SiOx).

Although the first inorganic layer 1211, the second inorganic layer 1212 and/or the third inorganic layer 1213 are disposed in the uppermost layer of the line layer 502 in the drawings, the inorganic layers 1210 may be regarded as being disposed in the lowermost layer of the light-emitting element layer.

The light-emitting element layer 503 may be disposed on the inorganic layers 1210 of the line layer 502, and the first electrodes ANE, the intermediate layer ML and the second electrode CAE of the light-emitting element layer 503 may be disposed thereon sequentially.

The first electrodes ANE of the light-emitting element layer 503 may be electrically connected to the driver element layer 501 disposed under the line layer 502 through a contact hole CT1211 penetrating the inorganic layers 1210.

The line layer 502 may include a trench TC from which the first inorganic layer 1211 and/or the second inorganic layer 1212 has been removed between the first electrodes ANE of adjacent pixels PX. According to the embodiment, the first inorganic layer 1211 may include undercut areas UC inside the trench TC, which are empty space under the second inorganic layer 1212. The undercut areas UC cause at least some conductive layers included in the intermediate layer ML to be disconnected during a process of depositing the intermediate layer ML.

According to the embodiment, the trench TC may include a first hole H1 from which the second inorganic layer 1212 is removed with a first width W1, and a second hole H2 from which the first inorganic layer 1211 removed with a second width W2. Since the second width W2 is greater than the first width W1, the undercut areas UC are formed on both sides of the second hole H2, respectively. Such undercut areas UC may be formed by over-etching the first inorganic layer 1211. For example, in order to form the trench TC, the etch rate for etching the first inorganic layer 1211 and the etch rate for etching the second inorganic layer 1212 may be adjusted.

According to the embodiment, parts of the intermediate layer ML formed during the process of depositing the intermediate layer ML and the second electrode CAE may be disposed in the trench TC. For example, a first portion ML1 that is a part of the intermediate layer ML and a second portion CAE1 that is a part of the second electrode CAE are disposed in the trench TC. The first portion ML1 of the intermediate layer ML disposed in the trench TC is disconnected from third portions ML2 of the intermediate layer ML disposed on the first electrodes ANE. On the other hand, the second portion CAE1 of the second electrode CAE disposed in the trench TC is continuously connected to fourth portions CAE2 of the second electrode CAE overlapping the first electrodes ANE. That is to say, the intermediate layer ML is disconnected around the trench TC, not continuously extending from the third portions MI,2 disposed on the first electrodes ANE to the first portion ML1 located in the trench TC. The second electrode CAE continuously extends from the fourth portions CAE2 overlapping the first electrodes ANE to the second portion CAE1 located in the trench TC. According to the embodiment, the intermediate layer ML of the light-emitting elements LEL is disconnected using the trench TC located between the adjacent first electrodes ANE, and leakage current is prevented.

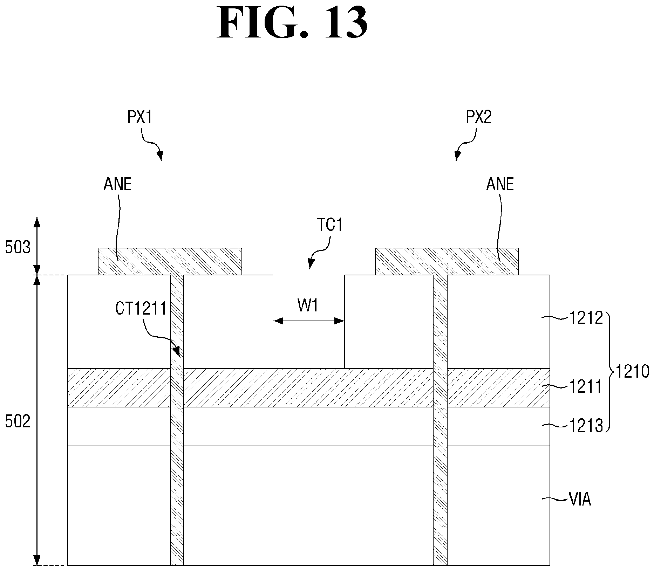

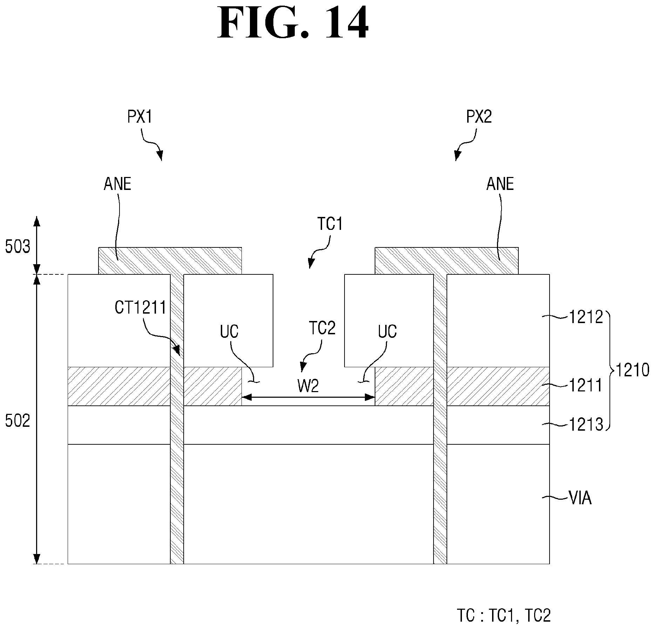

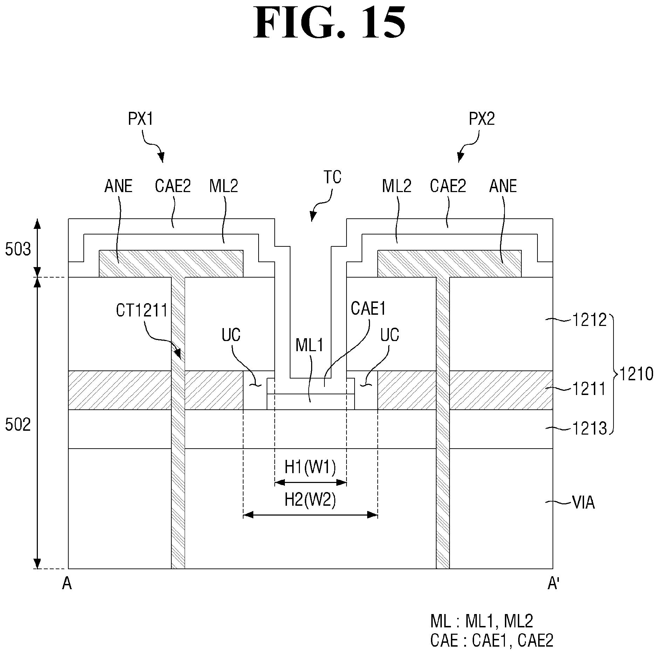

FIGS. 13 and 14 are cross-sectional views for illustrating processes of forming a trench TC according to an embodiment. FIG. 15 is a cross-sectional view for illustrating a process of depositing an intermediate layer ML and a second electrode CAE according to an embodiment. For example, FIGS. 13 to 15 may be views sequentially showing processes of fabricating the display panel 110 according to the embodiment of FIG. 12.

Hereinafter, a process of fabricating the display panel 110 according to an embodiment will be described with reference to FIGS. 13 to 15. It should be noted that only some of fabrication processes of the display panel 110 will be described. Other processes for forming the elements described herein may be additionally performed before or after the fabrication processes described below. In addition, fabrication processes of the display panel 110 known in the art may be additionally performed before or after the fabrication processes described below.

Referring to FIG. 13, the driver element layer 501 (not shown) is formed on the substrate 200, and the line layer 502 may be stacked on the driver element layer 501. In FIG. 13, the substrate 200, the driver element layer 501 and portions of the line layer 502 are not shown. In the uppermost layer of the line layer 502, a first inorganic layer 1211, a second inorganic layer 1212 on the first inorganic layer 1211, and/or a third inorganic layer 1213 under the first inorganic layer 1211 are disposed.

Subsequently, first electrodes ANE are formed on the line layer 502. The first electrodes ANE may be separately disposed in the pixels, and may be electrically connected to the driver element layer 501 through contact holes CT1211 extending through the line layer 502.

Subsequently, a photoresist pattern (not shown) having an opening may be formed between adjacent first electrodes ANE, and the second inorganic layer 1212 may be etched using the photoresist pattern thus formed as a mask. In this manner, a first trench TC1 having a first width W1 is formed between adjacent first electrodes ANE.

Subsequently, referring to FIG. 14, the first inorganic layer 1211 may be etched in the first trench TC1 using the photoresist pattern (not shown) having the opening between adjacent first electrodes ANE as a mask. The etch rate for etching the first inorganic layer 1211 may be adjusted differently from the etch rate for etching the second inorganic layer 1212, and accordingly, the first inorganic layer 1211 may be over-etched compared to the second inorganic layer 1212. A person of ordinary skill in the art will know how to adjust the etch rates of the first inorganic layer 1211 and the second inorganic layer 1212. Accordingly, a second trench TC2 having a second width W2 greater than the first width W1 is formed. Accordingly, a trench TC is formed between adjacent first electrodes ANE, and the trench TC includes undercut areas UC under the second inorganic layer 1212.

Subsequently, referring to FIG. 15, an intermediate layer ML is deposited to cover the plurality of first electrodes ANE, the second inorganic layer 1212, and the trench TC. At least some of the conductive layers included in the intermediate layer ML may be disconnected around the trench TC. Specifically, as the trench TC includes the undercut areas UC, the step coverage of the intermediate layer ML may be degraded around the trench TC, and thus it may be disconnected around the trench TC. Herein, at least some conductive layers of the intermediate layer ML may include at least one of: a hole injection layer HIL, a hole transport layer HTL, an electron transport layer ETL, a charge generation layer CGL, and a p-doped layer PHIL.

Subsequently, a second electrode CAE is deposited to cover the intermediate layer ML. Unlike the intermediate layer ML, the second electrode CAE may be continuously extended around the trench TC instead of being disconnected. This is because the metal of the second electrode CAE has better step coverage than the organic material of the intermediate layer ML.

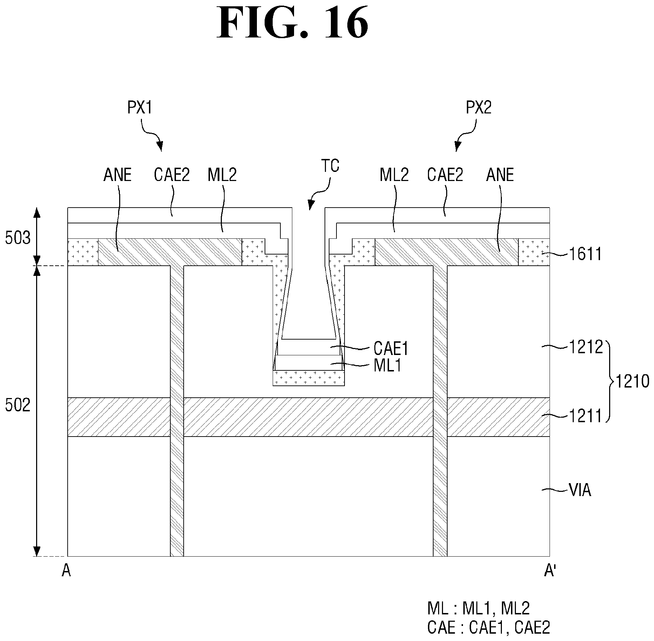

FIG. 16 is a cross-sectional view for illustrating another shape of a trench TC formed between adjacent pixels PX. For example, FIG. 16 is a cross-sectional view of some layers of the line layer 502 and the light-emitting elements LEL, taken along line A - A' shown in FIGS. 8 and 10.

The embodiment of FIG. 16 is substantially identical to the embodiment of FIG. 12 except that a third inorganic layer 1213 covers a trench TC in an inverted tapered shape.

Referring to FIG. 16, a display panel 110 further includes a dummy inorganic film 1611 disposed to surround the first electrodes ANE. The dummy inorganic film 1611 may include silicon oxide (SiOx). The dummy inorganic film 1611 is disposed to surround the first electrodes ANE but is not disposed on the first electrodes ANE. The dummy inorganic film 1611 covers a part of the trench TC in an inverted tapered shape such that the thickness of the dummy inorganic film 1611 covering the side surfaces of the trench TC becomes narrower with distance from the inlet of the trench TC to the bottom surface of the trench TC. The dummy inorganic film 1611 may, however, cover the base of the trench TC. The dummy inorganic film 1611 may cause at least some conductive layers included in the intermediate layer ML around the trench TC to be disconnected during the process of depositing the intermediate layer ML of the light-emitting elements LEL.

A process of depositing the dummy inorganic film 1611 by chemical vapor deposition (CVD) may be carried out as follows: In the chemical vapor deposition process, deposition and growth may be performed isotropically. Specifically, as the deposition process proceeds, thin films may be grown in the lateral direction at the boundary of the trench TC. The thin films grown in the lateral direction at the boundary of the trench TC may work as a deposition shadow that blocks the inlet of the trench TC and hinders deposition on the inside of the trench TC. This phenomenon is further aggravated as deposition and growth continue, and accordingly, the dummy inorganic film 1611 may have an inverted tapered shape in the trench TC.

According to an embodiment, a part of the dummy inorganic film 1611 is disposed on the bottom surface of the trench TC. In the trench TC, a first portion ML1 that is a part of the intermediate layer ML and a second portion CAE1 that is a part of the second electrode CAE are disposed on the dummy inorganic film 1611 at the base of the trench TC. The first portion ML1 of the intermediate layer ML disposed in the trench TC is disconnected from a third portion ML2 of the intermediate layer ML disposed on the first electrode ANE. On the other hand, the second portion CAE1 of the second electrode CAE disposed in the trench TC is continuously connected to fourth portions CAE2 of the second electrode CAE overlapping the first electrodes ANE. In contrast, the first portion of an intermediate layer ML1 is disconnected from the dummy inorganic film 1611 around the trench TC, and does not continuously extend from the third portions MI,2 disposed on the first electrodes ANE to the first portion ML1 located in the trench TC. The second electrode CAE is continuously disposed from the fourth portions CAE2, down the sidewall of the trench TC, covering the first electrodes ANE to the second portion CAE1 located in the trench TC. According to the embodiment, the intermediate layer ML of the light-emitting elements LEL is disconnected using the trench TC located between the adjacent first electrodes ANE, and leakage current is prevented.

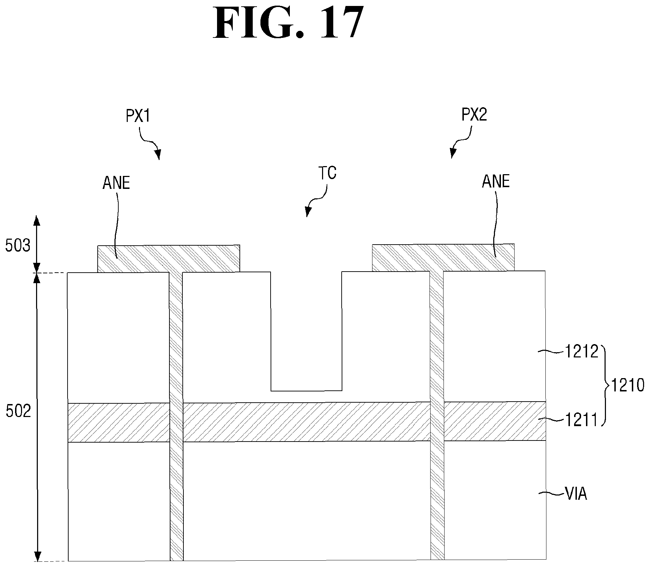

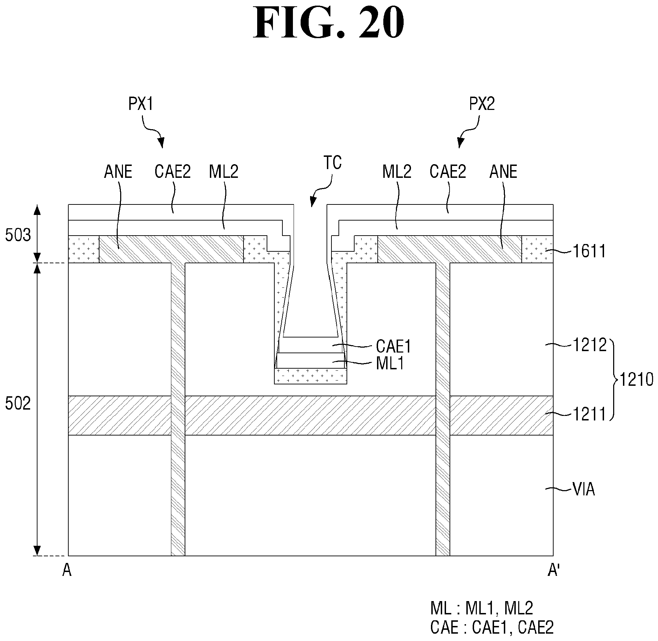

FIGS. 17 to 19 are cross-sectional views for illustrating a process of forming a trench TC according to an embodiment. FIG. 20 is a cross-sectional view for illustrating a process of depositing an intermediate layer ML and a second electrode CAE according to an embodiment. For example, FIGS. 17 to 20 may be views sequentially showing processes of fabricating the display panel 110 according to the embodiment of FIG. 16.

Hereinafter, a process of fabricating the display panel 110 according to an embodiment will be described with reference to FIGS. 17 to 20. It should be noted that only some of fabrication processes of the display panel 110 will be described. Other processes for forming the elements described herein may be additionally performed before or after the fabrication processes described below. In addition, fabrication processes of the display panel 110 known in the art may be additionally performed before or after the fabrication processes described below.

Referring to FIG. 17, a driver element layer 501 may be formed on a substrate 200, and a line layer 502 may be stacked on the driver element layer 501. In FIG. 17, parts of the substrate 200, the driver element layer 501 and the line layer 502 are omitted, and only inorganic layers 1210 in the uppermost layer among a plurality of insulating layers VIA included in the line layer 502 are shown. As shown in the drawings, the inorganic layers 1210 disposed in the uppermost layer of the line layer 502 include a first inorganic layer 1211, a second inorganic layer 1212 on the first inorganic layer 1211, and/or a third inorganic layer 1213 under the first inorganic layer 1211.

Subsequently, first electrodes ANE may be formed on the line layer 502. The first electrodes ANE may be separately disposed in the pixels, and may be electrically connected to the driver element layer 501 through contact holes CT1211 extending through the line layer 502.

Subsequently, a photoresist pattern (not shown) having an opening may be formed between adjacent first electrodes ANE, and the second inorganic layer 1212 may be etched using the photoresist pattern thus formed as a mask. In this manner, a trench TC having a first width W1 is formed between adjacent first electrodes ANE.

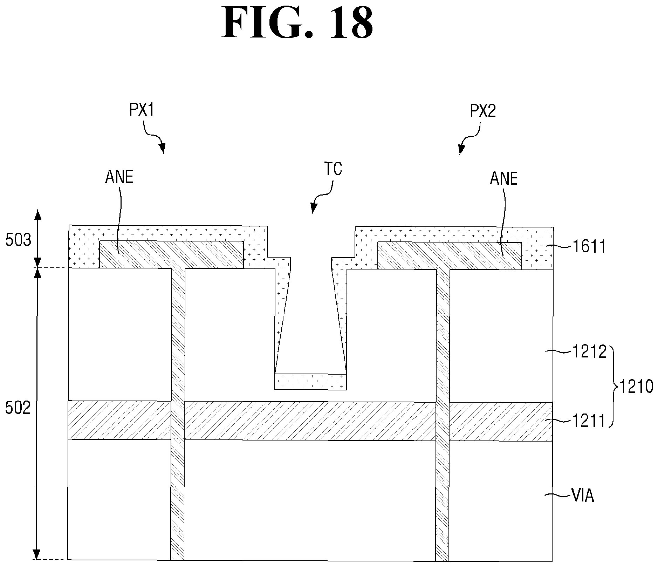

Subsequently, referring to FIG. 18, a dummy inorganic film 1611 may be deposited on the first electrodes ANE and the trench TC. The dummy inorganic film 1611 may be deposited by chemical vapor deposition (CVD) and may be deposited and grown isotropically. As the deposition process proceeds, thin films may be grown in the lateral direction at the boundary of the trench TC. The thin films grown in the lateral direction at the boundary of the trench TC may work as a deposition shadow that blocks the inlet of the trench TC and hinders deposition on the inside of the trench TC. This phenomenon is further aggravated as deposition and growth continue, and accordingly, the dummy inorganic film 1611 covers the trench TC such that the thickness of the dummy inorganic film 1611 covering the side surfaces of the trench TC becomes thinner with distance from the inlet of the trench TC. For example, the dummy inorganic film 1611 may be formed on the side surfaces of the trench TC, and the thickness of the dummy inorganic film 1611 formed on the upper parts of the side surfaces of the trench TC may be greater than the thickness of the dummy inorganic film 1611 formed on the lower parts of the side surfaces of the trench TC.

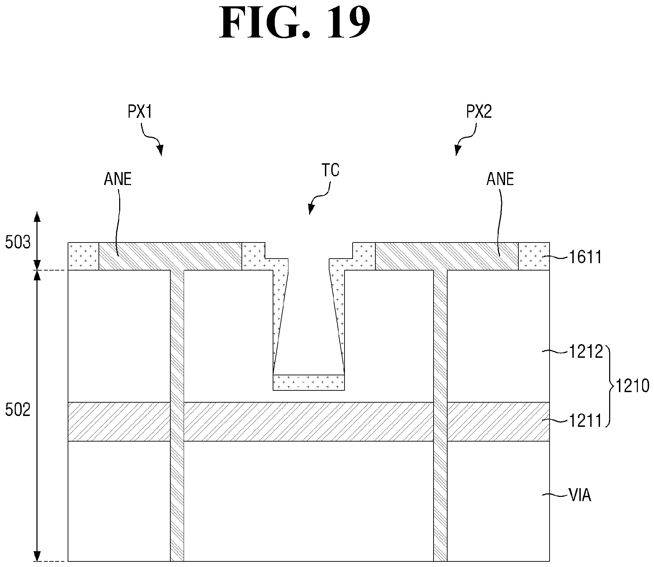

Subsequently, referring to FIG. 19, a photoresist pattern (not shown) associated with a plurality of first electrodes ANE, and a dummy inorganic film 1611 may be etched using the photoresist pattern thus formed as a mask. Accordingly, the dummy inorganic film 1611 deposited on the first electrodes ANE may be removed, and upper surfaces of the first electrodes ANE may be exposed.

Subsequently, referring to FIG. 20, an intermediate layer ML may be deposited to cover the first electrodes ANE, the dummy inorganic film 1611, and the trench TC. At least some of the conductive layers included in the intermediate layer ML may be disconnected around the trench TC. Specifically, as the thickness of the dummy inorganic film 1611 covering the side surfaces of the trench TC becomes thinner from the inlet of the trench TC to the bottom surface of the trench TC, the step coverage of the intermediate layer ML is degraded around the trench TC. Accordingly, the intermediate layer ML may be disconnected around the trench TC. Herein, at least some conductive layers of the intermediate layer ML may include at least one of: the hole injection layer HIL, the hole transport layer HTL, the electron transport layer ETL, the charge generation layer CGL, and the p-doped layer PHIL.

Subsequently, a second electrode CAE may be deposited to cover the intermediate layer ML. Unlike the intermediate layer ML, the second electrode CAE may be continuously extended around the trench TC instead of being disconnected. This is because the metal of the second electrode CAE has better step coverage than the organic material of the intermediate layer ML.

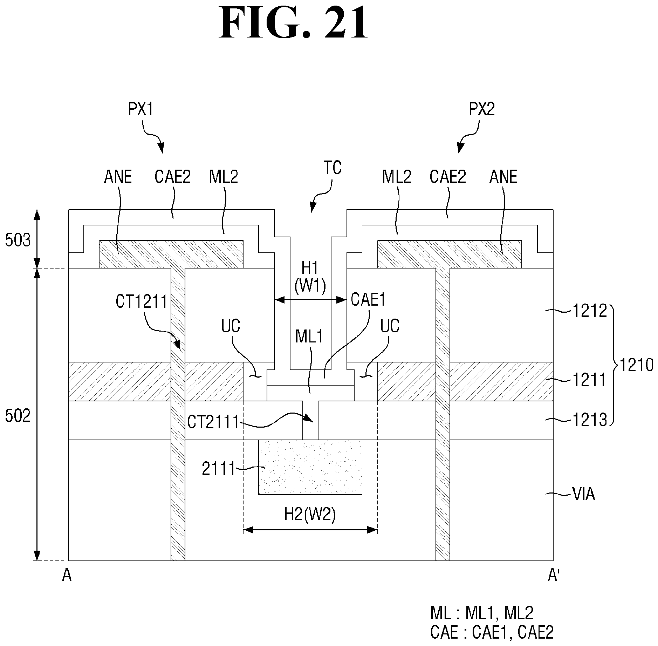

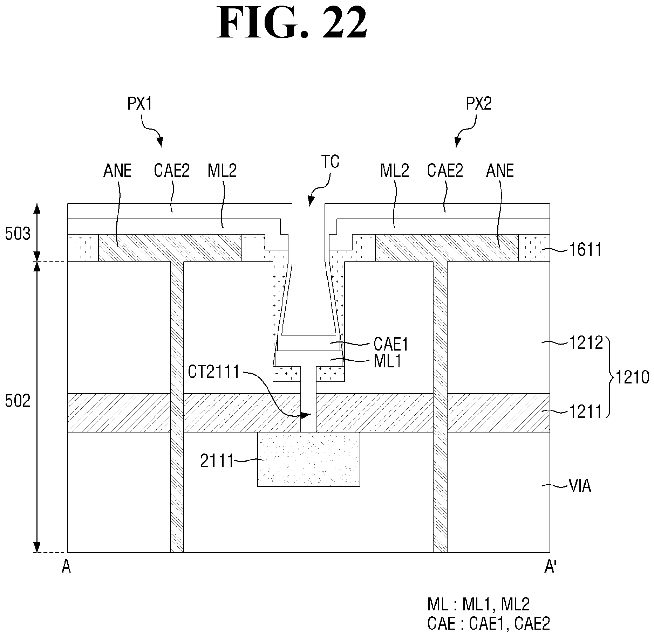

FIGS. 21 and 22 are cross-sectional views showing a display panel 110 including an auxiliary line 2111 according to an embodiment. For example, FIG. 21 shows an embodiment in which an auxiliary line 2111 in line with the bottom surface of a trench TC is further disposed compared to the embodiment of FIG. 12. For example, FIG. 22 shows an embodiment in which an auxiliary line 2111 in line with the bottom surface of a trench TC is further disposed compared to the embodiment of FIG. 16.

The embodiment of FIGS. 21 and 22 is substantially identical to the embodiment of FIG. 12 or the embodiment of FIG. 16 except for the difference; and, therefore, the redundant descriptions will be omitted.

Referring to FIGS. 21 and 22, a line layer 502 includes an auxiliary line 2111 disposed in line with a trench TC. The auxiliary line 2111 may be disposed in the same layer as signal lines or power lines included in the line layer 502. The auxiliary line 2111 disposed in the line layer 502 may be disposed to overlap the trench TC between adjacent pixels PX. The auxiliary line 2111 may be electrically connected to a first portion ML1 of the intermediate layer ML disposed on the bottom surface of the trench TC through a contact hole CT2111 penetrating the line layer 502 through the bottom surface of the trench TC. In the embodiment shown in FIG. 22, the contact hole CT2111 may penetrate not only the line layer 502 but also the dummy inorganic film 1611 deposited on the bottom surface of the trench TC.

In the display device 10 according to the embodiment, a ground voltage is applied to the auxiliary line 2111 while the display panel 110 displays images. The auxiliary line 2111 to which the ground voltage is applied may be electrically connected to the intermediate layer ML of the light-emitting elements LEL through the trench TC between adjacent pixels PX. Accordingly, leakage current flowing between adjacent pixels PX through the intermediate layer ML may flow to the outside through the auxiliary line 2111. According to this embodiment of the present disclosure, even if the intermediate layer ML fails to be disconnected around the trench TC in the deposition process of the intermediate layer ML, leakage current can be prevented using the auxiliary line 2111. As a result, the reliability can be increased.

No ground voltage may be supplied to the auxiliary line 2111, and a voltage different from the ground voltage may be applied to it. For example, an auxiliary voltage lower than the voltage for driving the plurality of pixels PX may be supplied to the auxiliary line 2111.

Although not shown in the drawings, no undercut area UC may be formed inside the trench TC, unlike the embodiment of FIG. 21. For example, in the display panel 110 including the auxiliary line 2111, leakage current flowing between adjacent pixels PX can be blocked by using the auxiliary line 2111, so that the undercut areas UC may be eliminated from the inside of the trench TC.

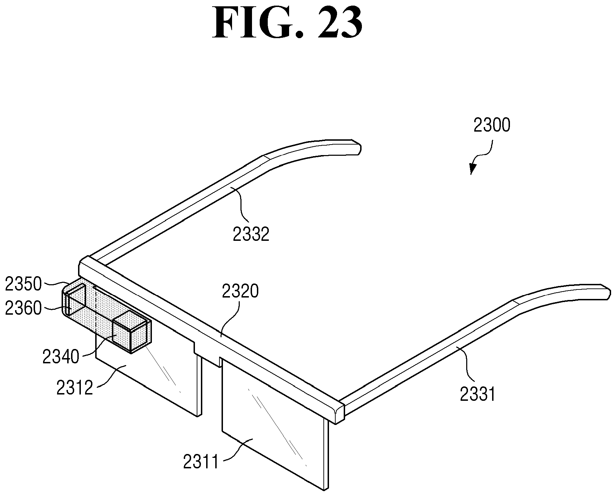

FIG. 23 is a view showing an example of a wearable device including a display device according to an embodiment of the present disclosure.

The display device 10 according to an embodiment may be included in a mobile electronic device. The display device 10 according to the embodiment may be included in a wearable device that is developed in the form of glasses or a helmet and forms a focus at a location close to the user's eyes. For example, a wearable device may be a head mounted display (HMD) device or an AR glass. Such a wearable device provides a user with an augmented reality (hereinafter referred to as "AR") screen or a virtual reality (hereinafter referred to as "VR") screen.

FIG. 23 shows a virtual reality device 2300 employing a display device 2360 according to an embodiment. The display device 2360 may include, for example, the above-described elements of FIGS. 1 to 22.

Referring to FIG. 23, the virtual reality device 2300 according to the embodiment may be AR glasses in the form of glasses. The virtual reality device 2300 according to the embodiment of the present disclosure may include the display device 2360, a left eye lens 2311, a right eye lens 2312, a support frame 2320, eyeglass temples 2331 and 2332, a reflective member 2340, and a display case 2350.

The case 2350 may include the display device 2360 and the reflective member 2340. An image displayed on the display device 2360 may be reflected by the reflective member 2340 and provided to the user's right eye through the right eye lens 2312. Accordingly, the user may watch a virtual reality image displayed on the display device 2360 through the right eye.

Although the case 2350 is disposed at the right end of the support frame 2320 in the example shown in FIG. 24, the embodiments of the present disclosure are not limited thereto. For example, the case 2350 may be disposed at the left end of the support frame 2320. In this instance, images displayed on the display device 2360 are reflected by the reflective member 2340 and provided to the user's left eye through the left eye lens 2311. Accordingly, the user may watch a virtual reality image displayed on the display device 2360 through the left eye. Alternatively, cases 2350 may be disposed at both the left and right ends of the support frame 2320, respectively. In this instance, the user can watch a virtual reality image displayed on the display device 2360 through both the left and right eyes.

In concluding the detailed description, those skilled in the art will appreciate that many variations and modifications can be made to the preferred embodiments without substantially departing from the principles of the present invention. Therefore, the disclosed preferred embodiments of the invention are used in a generic and descriptive sense only and not for purposes of limitation.

The present invention will now be defined with reference to the following clauses.
Clause 1. A display device comprising:
   a substrate;
   a driver element layer disposed on the substrate;
   a line layer disposed on the driver element layer and comprising a first inorganic layer and a second inorganic layer disposed on the first inorganic layer; and
   a light-emitting element layer disposed on the line layer and comprising a plurality of first electrodes, an intermediate layer, and a second electrode sequentially stacked on one another,
   wherein the line layer comprises a trench between the first electrodes, the trench being free of the first inorganic layer and the second inorganic layer, wherein the second inorganic layer comprises an undercut area under the first inorganic layer in the trench, wherein a first portion of the intermediate layer and a second portion of the second electrode are disposed in the trench, and
   wherein the first portion of the intermediate layer is disconnected from a third portion of the intermediate layer disposed on the first electrodes, and the second portion of the second electrode is connected to a fourth portion of the second electrode that overlap the first electrodes.
Clause 2. The display device of clause 1, wherein the trench comprises: a first hole in which the first inorganic layer is removed with a first width; and a second hole in which the second inorganic layer is removed with a second width greater than the first width, that second hole including the undercut area that extends beyond the sidewall of the first hole.
Clause 3. The display device of clause 1 or clause 2, wherein at least some of conductive layers of the intermediate layer are disconnected by the trench.
Clause 4. The display device of clause 3, wherein the second electrode is continuously disposed across the trench.
Clause 5. The display device of clause 3 or clause 4, wherein the at least some conductive layer comprise at least one layer of: a hole injection layer (HIL), a hole transport layer (HTL), an electron transport layer (ETL), a charge generation layer (CGL), and a p-doped layer (PHIL).
Clause 6. The display device of any one of clauses 1 to 5, wherein the line layer comprises an auxiliary line disposed in line with the trench, and wherein the auxiliary line is electrically connected to the first portion of the intermediate layer disposed on a bottom surface of the trench through a contact hole penetrating at least a portion of the line layer at the bottom surface of the trench.
Clause 7. The display device of clause 6, wherein a ground voltage is supplied to the auxiliary line.
Clause 8. The display device of clause 6, wherein an auxiliary voltage lower than a voltage for driving a plurality of pixels is applied to the auxiliary line.
Clause 9. The display device of any one of clauses 1 to 8, wherein the light-emitting element layer is configured to emit white light.
Clause 10. The display device of any one of clauses 1 to 9, wherein the light-emitting element layer emits light of a first color in a first emission area associated with a first pixel, emits light of a second color in a second emission area associated with a second pixel, and emits light of a third color in a third emission area associated with a third pixel.
Clause 11. A display device comprising:
   a substrate;
   a driver element layer disposed on the substrate;
   a line layer disposed on the driver element layer and comprising a first inorganic layer and a second inorganic layer disposed on the first inorganic layer; and
   a light-emitting element layer disposed on the line layer and comprising a plurality of first electrodes, a dummy inorganic film surrounding the plurality of first electrodes, an intermediate layer covering the plurality of first electrodes and the dummy inorganic film, a second electrode covering the intermediate layer,
   wherein the line layer comprises a trench between the first electrodes adjacent to each other, the first inorganic layer or the second inorganic layer being removed from the trench,
   wherein the dummy inorganic film is formed on side surfaces of the trench, and a thickness of the dummy inorganic film formed on upper parts of the side surfaces of the trench is greater than a thickness of the dummy inorganic film formed on lower parts of the side surfaces of the trench,
   wherein a first portion of the intermediate layer and a second portion of the second electrode are disposed on the dummy inorganic film in the trench, and
   wherein the first portion of the intermediate layer is disconnected from a third portion of the intermediate layer disposed on the first electrodes, and the second portion of the second electrode is continuously connected to a fourth portion of the second electrode disposed to overlap the plurality of first electrodes.
Clause 12. The display device of clause 11, wherein a width of the trench has an inverted tapered shape as a thickness of the dummy inorganic film covering side surfaces of the trench decreases from an inlet of the trench to a bottom surface of the trench.
Clause 13. The display device of clause 11 or clause 12, wherein at least some of conductive layers of the intermediate layer are disconnected by the trench.
Clause 14. The display device of clause 13, wherein the second electrode is continuously disposed across the trench.
Clause 15. The display device of clause 13 or clause 14, wherein the at least some conductive layer comprise at least one layer of: a hole injection layer (HIL), a hole transport layer (HTL), an electron transport layer (ETL), a charge generation layer (CGL), and a p-doped layer (PHIL).
Clause 16. A method of fabricating a display device, the method comprising:
   forming a driver element layer on a substrate;
   forming a line layer on the driver element layer, the line layer comprising a first inorganic layer and a second inorganic layer disposed on the first inorganic layer; and
   forming a light-emitting element layer on the line layer,
   wherein the forming the light-emitting element layer comprises:
      forming a plurality of first electrodes on the second inorganic layer;
      forming a first trench having a first width by removing the second inorganic layer between adjacent first electrodes;
      forming a second trench having a second width greater than the first width by overly etching the first inorganic layer in the first trench;
      depositing an intermediate layer to cover the plurality of first electrodes, the second inorganic layer, and the first and second trenches; and
      depositing a second electrode to cover the intermediate layer,
   wherein the intermediate layer is disconnected around the first trench and the second trench in the depositing the intermediate layer.
Clause 17. The method of clause 16, wherein the second electrode is not disconnected around the first trench and the second trench but is continuously connected in the depositing the second electrode.
Clause 18. The method of clause 16 or clause 17, wherein the light-emitting element layer is configured to emit white light.
Clause 19. The method of any one of clauses 16 to 18, wherein the light-emitting element layer emits light of a first color in a first emission area associated with a first pixel, emits light of a second color in a second emission area associated with a second pixel, and emits light of a third color in a third emission area associated with a third pixel.
Clause 20. The method of any one of clauses 16 to 19, wherein the substrate comprises a semiconductor wafer substrate.
Clause 21. A display device comprising:
   a substrate;
   a driver element layer disposed on the substrate;
   a line layer disposed on the driver element layer and comprising a first inorganic layer and a second inorganic layer disposed on the first inorganic layer; and
   a light-emitting element layer disposed on the line layer and comprising a plurality of first electrodes, an intermediate layer, and a second electrode sequentially stacked on one another,
   wherein the line layer comprises a trench between the adjacent first electrodes in which the first inorganic layer or the second inorganic layer are removed,
   wherein a first portion of the intermediate layer is disposed in the trench, and
   wherein an auxiliary line is electrically connected to the first portion of the intermediate layer.
Clause 22. The display device of clause 21, wherein a width of the trench has an inverted tapered shape as a thickness of the dummy inorganic layer covering side surfaces of the trench decreases from an inlet of the trench to a bottom surface of the trench.
Clause 23. The display device of clause 21 or clause 22, wherein at least some of conductive layers of the intermediate layer are disconnected at a boundary of the trench.

## Claims

1. A display device comprising:
a substrate;
a driver element layer disposed on the substrate;
a line layer disposed on the driver element layer and comprising a first inorganic layer and a second inorganic layer disposed on the first inorganic layer; and
a light-emitting element layer disposed on the line layer and comprising a plurality of first electrodes, an intermediate layer, and a second electrode sequentially stacked on one another,
wherein the line layer comprises a trench between the first electrodes, the trench being free of the first inorganic layer and the second inorganic layer, wherein the first inorganic layer comprises an undercut area under the second inorganic layer in the trench, wherein a first portion of the intermediate layer and a second portion of the second electrode are disposed in the trench, and
wherein the first portion of the intermediate layer is disconnected from a third portion of the intermediate layer disposed on the first electrodes, and the second portion of the second electrode is connected to a fourth portion of the second electrode that overlap the first electrodes.

2. The display device of claim 1, wherein the trench comprises: a first hole in which the second inorganic layer is removed with a first width; and a second hole in which the first inorganic layer is removed with a second width greater than the first width, that second hole including the undercut area that extends beyond the sidewall of the first hole.

3. The display device of claim 1 or claim 2, wherein at least some of conductive layers of the intermediate layer are disconnected by the trench.

4. The display device of claim 3, wherein:
(i) the second electrode is continuously disposed across the trench; and/or
(ii) the at least some conductive layer comprise at least one layer of: a hole injection layer (HIL), a hole transport layer (HTL), an electron transport layer (ETL), a charge generation layer (CGL), and a p-doped layer (PHIL).

5. The display device of any one of claims 1 to 4, wherein the line layer comprises an auxiliary line disposed in line with the trench, and wherein the auxiliary line is electrically connected to the first portion of the intermediate layer disposed on a bottom surface of the trench through a contact hole penetrating at least a portion of the line layer at the bottom surface of the trench, optionally wherein:
(i) a ground voltage is supplied to the auxiliary line; or
(ii) an auxiliary voltage lower than a voltage for driving a plurality of pixels is applied to the auxiliary line.

6. The display device of any one of claims 1 to 5, wherein:
(i) the light-emitting element layer is configured to emit white light; and/or
(ii) the light-emitting element layer emits light of a first color in a first emission area associated with a first pixel, emits light of a second color in a second emission area associated with a second pixel, and emits light of a third color in a third emission area associated with a third pixel.

7. A display device comprising:
a substrate;
a driver element layer disposed on the substrate;
a line layer disposed on the driver element layer and comprising a first inorganic layer and a second inorganic layer disposed on the first inorganic layer; and
a light-emitting element layer disposed on the line layer and comprising a plurality of first electrodes, a dummy inorganic film surrounding the plurality of first electrodes, an intermediate layer covering the plurality of first electrodes and the dummy inorganic film, a second electrode covering the intermediate layer,
wherein the line layer comprises a trench between the first electrodes adjacent to each other, the first inorganic layer or the second inorganic layer being removed from the trench,
wherein the dummy inorganic film is formed on side surfaces of the trench, and a thickness of the dummy inorganic film formed on upper parts of the side surfaces of the trench is greater than a thickness of the dummy inorganic film formed on lower parts of the side surfaces of the trench,
wherein a first portion of the intermediate layer and a second portion of the second electrode are disposed on the dummy inorganic film in the trench, and
wherein the first portion of the intermediate layer is disconnected from a third portion of the intermediate layer disposed on the first electrodes, and the second portion of the second electrode is continuously connected to a fourth portion of the second electrode disposed to overlap the plurality of first electrodes.

8. The display device of claim 7, wherein a width of the trench has an inverted tapered shape as a thickness of the dummy inorganic film covering side surfaces of the trench decreases from an inlet of the trench to a bottom surface of the trench.

9. The display device of claim 7 or claim 8, wherein at least some of conductive layers of the intermediate layer are disconnected by the trench, optionally wherein:
(i) the second electrode is continuously disposed across the trench; and/or
(ii) the at least some conductive layer comprise at least one layer of: a hole injection layer (HIL), a hole transport layer (HTL), an electron transport layer (ETL), a charge generation layer (CGL), and a p-doped layer (PHIL).

10. A method of fabricating a display device, the method comprising:
forming a driver element layer on a substrate;
forming a line layer on the driver element layer, the line layer comprising a first inorganic layer and a second inorganic layer disposed on the first inorganic layer; and
forming a light-emitting element layer on the line layer,
wherein the forming the light-emitting element layer comprises:
forming a plurality of first electrodes on the second inorganic layer;
forming a first trench having a first width by removing the second inorganic layer between adjacent first electrodes;
forming a second trench having a second width greater than the first width by overly etching the first inorganic layer in the first trench;
depositing an intermediate layer to cover the plurality of first electrodes, the second inorganic layer, and the first and second trenches; and
depositing a second electrode to cover the intermediate layer,
wherein the intermediate layer is disconnected around the first trench and the second trench in the depositing the intermediate layer.

11. The method of claim 10, wherein the second electrode is not disconnected around the first trench and the second trench but is continuously connected in depositing the second electrode.

12. The method of claim 10 or claim 11, wherein:
(i) the light-emitting element layer is configured to emit white light; and/or(ii) the light-emitting element layer emits light of a first color in a first emission area associated with a first pixel, emits light of a second color in a second emission area associated with a second pixel, and emits light of a third color in a third emission area associated with a third pixel.

13. The method of any one of claims 10 to 12, wherein the substrate comprises a semiconductor wafer substrate.

14. A display device comprising:
a substrate;
a driver element layer disposed on the substrate;
a line layer disposed on the driver element layer and comprising a first inorganic layer and a second inorganic layer disposed on the first inorganic layer; and
a light-emitting element layer disposed on the line layer and comprising a plurality of first electrodes, an intermediate layer, and a second electrode sequentially stacked on one another,
wherein the line layer comprises a trench between the adjacent first electrodes in which the first inorganic layer or the second inorganic layer are removed,
wherein a first portion of the intermediate layer is disposed in the trench, and
wherein an auxiliary line is electrically connected to the first portion of the intermediate layer.

15. The display device of claim 14, wherein:
(i) a width of the trench has an inverted tapered shape as a thickness of the dummy inorganic layer covering side surfaces of the trench decreases from an inlet of the trench to a bottom surface of the trench; and/or
(ii) at least some of conductive layers of the intermediate layer are disconnected at a boundary of the trench.
